# EUROPEAN PATENT SPECIFICATION

(11) **EP 0 393 087 B1**
(45) Date of publication and mention of the grant of the patent: **18.12.1996**
(21) Application number: 88909930.5
(22) Date of filing: 22.09.1988
(51) Int. Cl.: G06F 5/00, G06F 7/00, H03M 7/46

(54) **A BIT STRING COMPRESSOR WITH BOOLEAN OPERATION PROCESSING CAPABILITY**
BITKETTENVERDICHTER MIT VERARBEITUNGSMÖGLICHKEIT FÜR BOOLESCHE-OPERATIONEN
COMPRESSEUR DE CHAINE BINAIRE A POUVOIR DE TRAITEMENT D'OPERATIONS BOOLEENNES

(30) Priority: 24.09.1987 US 100761; 22.04.1988 US 185888
(43) Date of publication of application: 24.10.1990
(60) Divisional application: 95202343.0
(73) Proprietor: Sand Technology Systems International, Inc., Westmount, Quebec H3Z 1B8 (CA)
(72) Inventor: GLASER, Edward, Lewis, Santa Monica, CA 90403 (US); DESJARDINS, Paul, Russell, Long Beach, CA 90808 (US); CALDWELL, Douglas, Wyche, Los Angeles, CA 90049 (US); GLASER, Eliot, Dixon, Van Nuys, CA 91406 (US)
(74) Representative: Enskat, Michael Antony Frank
(86) International application number: US8803300
(87) International publication number: WO8903084

(56) References cited:
- EP-A- 0 180 469
- US-A- 4 117 470
- US-A- 4 319 225
- US-A- 4 558 302
- US-A- 4 586 027
- US-A- 4 626 829
- US-A- 4 706 265

## Description

This invention relates to a method and apparatus for converting a string of repetitive data comprising a string of binary bits of indefinite length into a compressed impulse format upon which boolean operations can be performed.

Technological developments from the invention of the printing press through automatic acquisition of data from space exploration have foisted the information explosion on us. However, the ever growing numbers of warehouses of data, such as hard copy records, magnetic tapes, etc, attest to the need for somehow condensing the representation of data while preserving its information content. Furthermore, there is a need for quickly and economically performing boolean operations on this data without decompressing the data to its original form.

There are two basic data compression techniques used in computers which are generally described in the prior art; first, data compression techniques which compress data stored in a database and second, bit string compression techniques which compress strings of bits representative of data.

A typical computer method of data compression monitors the statistics of data in a database and modifies data encoding in accordance therewith. For example, Huffman encoding uses a variable length code to achieve data compaction in a large database. See Date, An Introduction to Database Systems, 4th Edition, 79-80 (1986). In accordance with the Huffman encoding scheme, characters or other basic items of information which are to be processed are encoded into bit strings of varying length, with the shortest strings being assigned to the most frequently occurring items of data. In this way, the bit strings representing these items have an average length which is much less than that of bit strings representing such items in a conventional fixed length code format.

Another computer method of data compression is a holotropic system as disclosed in US Patent 4,068,298 to Dechant et al. A holotropic system compresses data by automatically taking advantage of any redundancy in the data. For example, once a character, a word, a sentence, a paragraph, etc has been encountered, no subsequent occurrence of that same element need be stored in its original form. Instead, the holotropic system notes that a previously encountered element has occurred in a manner which permits reconstruction of any or every one of the multiple data elements in its original context. Another feature of a holotropic system is that after each data element is added to the database it can be automatically correlated with any other element already stored. This correlation can reveal a relationship between a particular data element and a number of already stored data elements which permits all of the related elements to be treated as a single entity and stored together. Thus, a number of elements which were stored separately, can be collapsed into one entry in the database.

Data compression methods, as discussed above, require a sizable amount of hardware and software for their implementation, such as probability distribution analyzers, prediction function generators, etc. Data compression may also result in actual expansion of the information because the information source statistics may not be measurable to the required precision. Additionally, the resulting bit strings representative of the compressed data are not easily operated on by boolean operators. Usually, data must be converted back to its original fixed length formats before boolean operations can be performed.

The second category of techniques disclosed by the prior art involves methods for bit string compression by using run-length encoding schemes to represent strings of identical bit values ("1's" or "O's"). One aspect of the present invention is an improvement related to these compression techniques. These methods are generally data independent unlike the data compression techniques mentioned above. A typical application for run length encoding is employed to reduce the number of bits in redundant binary data such as digitized images of engineering drawings or transmissions of data from outer space. In Bradley, "Optimizing a Scheme for Run Length Encoding", Proceedings of the IEEE (Jan. 1969) a scheme is presented for depicting an image which is represented by a two-dimensional array of black and white picture elements. Because the appearance of black and white pixels always alternates in an image, in the encoding process it is only necessary to encode the length of a run of white pixels and not the value of its picture elements. A variable length encoding scheme is introduced for encoding the image, specifically, two encoding formats are discussed. The first encoding format encodes a run of zeros followed by a terminating one to mark the end of the run. The second encoding format simply encodes a string of consecutive zeros. A run of any arbitrary length can be represented by several code entries of the second entry type followed by a single entry from the first type.

US Patent No 4,586,027 discloses a method and an apparatus for data compression and restoration. An input data string that includes repetitive data more in number than a specified value is transformed into an output data string that includes a first region for uncompressed data and a second region for compressed data. The second region includes a datum value representative of a data string section that has undergone the compression process and a quantity value indicating the number of repetitions. Thus, a two-part compressed format is used to represent a string of repetitive bytes comprising a one-byte data indicator and numerical information indicating the number of repetitions of the one-byte data indicator in the original data string.

Although the run-length encoding schemes, as discussed in the prior art (eg Bradley), are efficient for compressing images and large transmissions of data where there are long runs of "0's", they are not amenable to traditional forms of computer processing, particularly in the setting where the run lengths are considerably shorter and the frequency variation of runs of "1's" and "0's" occurs more often. Additionally, the prior art run-length encoding schemes are not structured for efficiently performing operations (eg boolean operations, etc) on data. Fixed length compressed formats, on the other hand, are amenable to computer operations. Specifically, fixed length formats can be operated on in an efficient fashion and then can be used for efficiently encoding uncompressed bit strings.

Lastly, to date there has been little development in the techniques for efficiently performing boolean operations on compressed bit strings. Traditional techniques require that boolean operations be performed on each bit of data. These techniques have been slightly enhanced via the use of faster hardware; however, each bit of data must still be evaluated. Therefore, performing boolean operations on bit strings remains a relatively inefficient process.

According to the present invention there is provided a method as defined in Claim 1.

According to the present invention there is further provided a processor as defined in Claim 7.

According to the present invention there is still further provided an apparatus as defined in Claim 8.

The present invention thus has the capability of efficiently performing an operation on a first and a second bit string which are both in a compressed form. For the first time, compressed bit strings need not be decompressed in order to perform data manipulation operations. Computer time is saved by not having to decompress the data and processing is made more efficient because less data needs to be considered while performing the Boolean operations. This aspect of the present invention is a method and/or apparatus using a computer for efficiently processing binary bit strings. Each binary bit string is represented by a series of compressed impulse formats. The compressed impulse formats comprise a polarity representation and a corresponding length representation pair. The polarity representation represents the binary value of one or more contiguous binary bits of the same binary value and a binary bit of the opposite binary value in the corresponding bit string. The length representation, in the pair, represents the quantity of binary bits of the same binary value. Generally, processing binary bit strings occurs in two steps. First, a first series of the compressed impulse formats representing a first bit string are processed, according to a selected operation, with a second series of the compressed impulse formats representing a second bit string. An intermediate format results which represents a portion of a resultant bit string. The intermediate format, typically contains a plurality of run representations and impulses. Second, the runs and impulses in the intermediate format are combined into a series of contiguous compressed format impulses representing the resultant bit string.

The present invention contains two embodiments for processing Boolean operations. In the first embodiment, processing a Boolean operation on the first and the second compressed bit string occurs in six steps. In the first step, the length of the first impulse is compared with the length of a second impulse to determine a minimum length. The minimum length is the length of an intermediate compressed bit string (intermediate bit string) which is calculated by processing two impulses, one from each bit string. Second, an operation is performed on the minimum length of the first and the second impulses to determine the polarity of the intermediate bit string and whether the intermediate bit string is a run or an impulse.

Third, the polarity, the length and the type (run or impulse) of the intermediate bit string are stored in a temporary memory area. Here, one or more of the intermediate bit strings are combined into an impulse of a resultant bit string. The fourth step involves reducing the length of the first and the second input impulses by the minimum length previously calculated. This step accounts for the bits of each impulse which have been processed for a particular Boolean operation.

The fifth step determines whether the length of the first and/or second impulses have been reduced to zero bits. This determination enables the system to evaluate if it needs to obtain a next impulse in either the first or second bit strings. Specifically, next impulses are obtained from both the first and second bit strings when the first and second impulses are reduced to zero length. Or, a next impulse of the first or second bit string is obtained when the corresponding impulses are reduced to a zero length. The last step involves performing all the prior recited steps until no more impulses reside in the first and/or second bit string(s).

In the preferred embodiment, the step for performing a Boolean operation also includes the step for referencing an index table to determine which specific operation to perform. The index table is made up of a series of subtables. Each subtable corresponds to a particular Boolean operation and each of the subtables contains a matrix of desired results for each operation. Each one of the subtables also comprises a first, a second and a third index. The first index of the subtable is for identifying the polarity of the first impulse. The second index of the subtable is for identifying the polarity of the second impulse. Lastly, the third index is for identifying whether the length of the first impulse length is less than, greater than or equal to the length of the second impulse. By referring to the first, second and third indexes, the predefined operations to be performed can be determined.

In the second preferred embodiment, the method for processing a Boolean operation occurs in seven steps. The second embodiment of the preferred embodiment is specifically for performing the Boolean operations AND, OR or EXCLUSIVE OR on a first and a second compressed bit string. In the first step, the length of a first impulse is compared with the length of a second impulse to determines whether the first and the second impulse lengths are equal or unequal in length. The second step involves determining an intermediate resultant bit-string when the first and second impulses are equal or unequal in length.

When the impulses are unequal in length, three substeps are performed. First, the length of the first impulse is compared with the length of the second impulse to determine which impulse has a longer length and which impulse has a shorter length. The shorter length is the length of the intermediate bit string. Second, the polarity of the longer impulse is determined by referring to the polarity indicator associated with the impulse. Third, a determination of whether the intermediate bit string is an impulse or a run is made. Specifically, this substep involves evaluating three separate rules. Rule I, when the Boolean operation is an AND operation, the polarity of the longer impulse (as determined above) indicates whether the intermediate bit string is a run or an impulse. Rule II, when the Boolean operation is an OR operation, the complement of the polarity of the longer impulse indicates whether the intermediate bit string is a run or an impulse. Lastly, Rule III, when the Boolean operation is EXCLUSIVE OR, the intermediate bit string is always an impulse.

When the first and second bit strings are of equal length, the second step involves determining the intermediate bit string by following two substeps. First, the length of the intermediate bit string is set equal to the length of the first and the second impulses. Second, a determination of whether the intermediate bit string is a run or an impulse is made. This substep involves evaluating three rules. Rule I, when the Boolean operation is either an AND or an OR operation, and the polarity of the first and the second impulses is different, the intermediate bit string is always a run. Rule II, when the Boolean operation is either an AND or an OR and the polarity of the first and the second impulses is the same, the intermediate bit string is always an impulse. Rule III, when the Boolean operation is EXCLUSIVE OR, the intermediate bit string is always a run.

Regardless of whether the second step discussed above involves determining the intermediate bit string when the first and second bit strings are equal or unequal in length, the third step will perform a particular Boolean operation on the first indicator of the first impulse with the first indicator of the second impulse to determine the polarity of the intermediate bit string. The polarity, the length and the type (run or impulse) of the intermediate bit string are stored in a temporary memory area. Here, one or more intermediate bit strings are combined into an impulse of the resultant bit string. In the fifth step, the length of the first and second impulses are reduced by the length of the intermediate bit string. This step accounts for the bits which have been previously processed by the Boolean operation.

The sixth step involves determining whether the length of the first and/or second impulses has been reduced to zero. This determination enables the system to determine whether a next impulse from the first and second bit strings should be obtained. More particularly, next impulses of the first and second bit strings are obtained when the first and second impulses are both reduced to zero bit lengths, or a next impulse of the first or the second bit strings is obtained when the corresponding impulse is reduced to a zero length. The last step performs all the previous recited steps until no more impulses reside in either the first or second bit string. In this way, a method is provided for processing the Boolean operation AND, OR, or EXCLUSIVE OR on a first and a second bit string to construct a resultant compressed bit string.

The present invention also contains an embodiment for processing Boolean operations on first and second bit strings containing only compressed runs. In the preferred embodiment, each run of a bit string is converted to a compressed run format. The compressed run format contains a first and a second indicator. The first indicator is for indicating the polarity of the run, and the second indicator is for indicating the length of the run. Performing a Boolean operation on two bit strings containing runs occurs in the two steps. First, a run of a first bit string and a run of a second bit string are compared to determine if they are equal or unequal in length. If the run lengths are unequal, the bit length of the shorter run is equal to the bit length of the intermediate resultant run. If the runs are equal in length, the bit length of either run is equal to the bit lengths of the resultant run. The second step involves determining the polarity of the resultant run. The specified boolean operation is performed on the polarity indicators of the first and second runs. The result of the boolean operation is the polarity of the intermediate resultant run. These steps are performed until all of the runs of both bit strings are processed and a compressed resultant run is determined.

This embodiment of the present invention significantly enhances a computer's capability for processing boolean operations on compressed data. Specifically, data can be efficiently processed in a compressed form without having to first decompress the data into its originally unencoded form. Additionally, by using an index table and/or the boolean rules for determining type (run or impulse), boolean operations can be efficiently performed on large amounts of compressed data. By taking advantage of the unique properties of impulses, the present invention more efficiently processes data.

### Brief Description of the Diagrams

FIG. 1 depicts a computer system equipped with the computer platform for converting uncompressed bit strings into compressed bit strings and/or for processing Boolean operations in accordance with the present invention;
FIG. 1A depicts the computer platform hardware on which software programs and/or hardware are performed for conversion and Boolean operation performance;
FIG. 2A is a schematic representation of a one-pack compressed impulse format for representing an impulse having a length of 2 to 31 bits;
FIG. 2B is a two-pack compressed impulse format for representing a first and a second impulse having a length of 2 to 5 bits;
FIG. 2C is a three-pack compressed impulse format for representing three impulses having a length of 2 to 3 bits;
FIG. 2D is a four-pack compressed impulse format for representing an impulse having a length of 2 to 2³²-1 bits;
FIGS. 3A and 3B are flow block diagrams of the ENCODE BIT STRING routine;
FIG. 3C is a flow block diagram of the GET NEXT IMPULSE routine which is called in the ENCODE BIT STRING routines (FIGS. 3A and 3B);
FIG. 4A depicts an uncompressed bit string;
FIG. 4B is the bit string of FIG. 4A represented in the compressed impulse format;
FIGS. 5A and 5B are tables depicting results of the ENCODE BIT STRING routine (FIG. 3A and 3B) and the GET NEXT IMPULSE routine (FIG. 3C) performed on the uncompressed bit string (FIG. 4A);
FIG. 6 is a flow block diagram of the PROCESS BOOLEAN OPERATION routine;
FIG. 7 is a schematic block diagram depicting a portion of the computer hardware embodiment for performing a Boolean operation on a first and a second bit string;
FIG. 8A is a table depicting the results of the F2 function of the Boolean hardware configuration (FIG. 7);
FIG. 8B is a table depicting the results of the F3 function of the Boolean hardware configuration (FIG. 7);
FIG. 9A is a truth table representation of the inputs and the results to the F1 function of the Boolean hardware configuration (FIG. 7);
FIG. 9B is a truth table representation of the inputs and results of the F2 function of the Boolean hardware configuration (FIG. 7);
FIG. 9C is a truth table representation of the inputs and results of the F4 function of the Boolean hardware configuration (FIG. 7);
FIG. 9D is a truth table representation of the inputs and results of the F3 function of the Boolean hardware configuration (FIG. 7);
FIG. 9E is a truth table representation of the inputs and results of the F6 function of the Boolean hardware configuration (FIG. 7);
FIG. 9F is a truth table representation of the inputs and results of the F₂ and F₃ functions of the Boolean hardware configuration (FIG. 7).
FIG. 10 depicts an index table used by the computer platform for performing a Boolean operation on a first and second bit string;
FIG. 11A is a flow block diagram of the GENERATE RESULTANT BIT STRING routine;
FIG. 11B is a schematic diagram of a state variable;
FIG. 11C is a schematic block diagram which depicts the hardware components of the canonical processor 25 (FIG. 1) ;
FIG. 12A depicts a second index table used by the computer platform for determining a state variable to be analyzed by the GENERATE RESULTANT BIT STRING routine (FIG. 11A) ;
FIG. 12B is a table depicting the operations performed by the GENERATE RESULTANT BIT STRING routine (FIG. 11A) as set forth by the state variables;
FIG. 13A depicts compressed bit strings A and B which are to be processed by a Boolean operation;
FIG. 13B depicts a resultant bit string generated by processing a Boolean operation on bit strings A and B of FIG. 13A; and
FIGS. 14A and 14B are a table depicting results of performing the Boolean AND operation on bit strings A and B of FIG. 13A.

### INDEX

### Contents

I. CONVERTING UNCOMPRESSED BIT STRINGS INTO COMPRESSED BIT STRINGS
   A. Example of Converting Uncompressed Bit Strings Into Compressed Bit Strings
II. OPERATIONS ON BIT STRINGS
   A. Hardware Embodiment for Performing Boolean Operations on Compressed Impulses
   B. Embodiment for Performing Boolean Operations on Compressed Impulses
   C. Performing Boolean Operations on Compressed Runs
   D. Canonical Processing of Intermediate Bit Strings
      1) Generate Resultant Bit String Routine
      2) Second Index Table
      3) A Detailed Example of the Boolean AND Operation With Two Compressed Bit Strings

### Detailed Description of the Diagrams

### I. CONVERTING UNCOMPRESSED BIT STRINGS INTO COMPRESSED BIT STRINGS

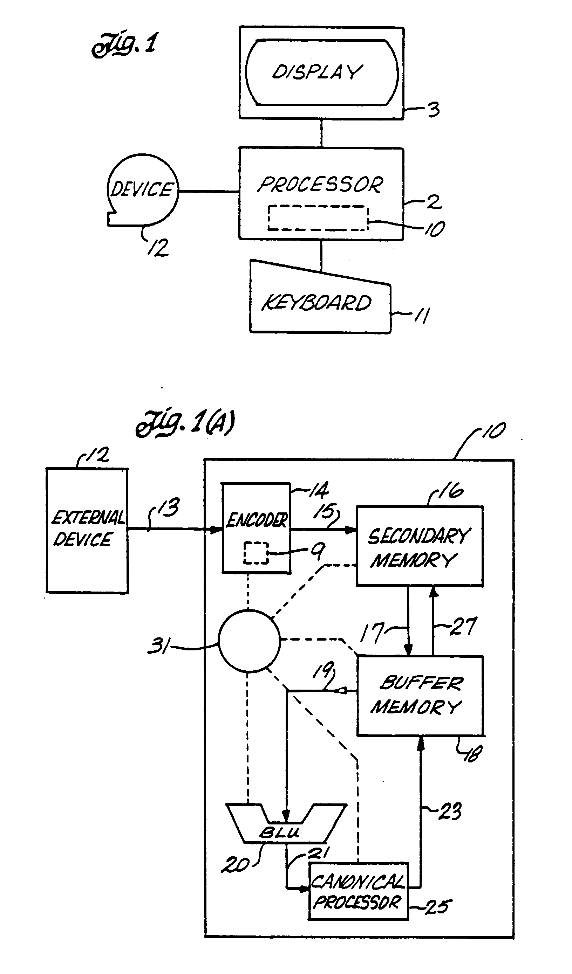

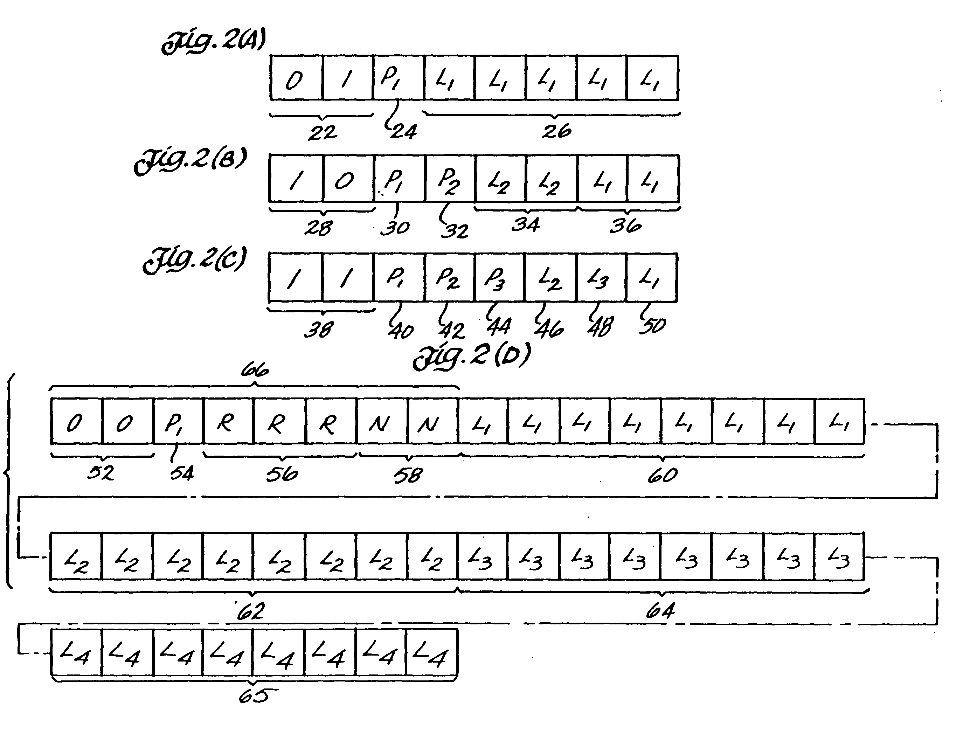

FIG. 1 depicts a computer system having a programmable computer and computer programs for converting an uncompressed string of bits into a compressed string of bits and/or for processing Boolean operations on a first and a second compressed bit string. The system includes a programmed microprocessor 2, display 3, keyboard entry 11 for the microprocessor and external device 12 for storage or buffering of the uncompressed bit strings. Conversion hardware/software and Boolean operation hardware/software are housed in a computer platform 10 (shown in phantom lines), which is built into the processor 2. The computer platform 10 coordinates the various activities related to converting uncompressed bit strings into compressed bit strings and to performing Boolean operations on bit strings. Conventionally, computer platform 10 is a preprogrammed computer on a printed circuit board which can be easily employed within most standard computers, including personal, minicomputers and mainframe computers. It is also envisioned that platform 10 may be a special purpose computer formed by an integrated circuit chip.

More particularly, referring to FIG. 1A, computer platform 10 includes an encoder 14, an optional secondary memory 16, (i.e., secondary memory may have been located external to platform 10) an optional buffer memory 18, a Boolean Logic Unit (BLU) 20, canonical processing unit 25 and a system coordinator 31. When software programs for encoding the bit strings, processing the Boolean operations, and coordinating data transfer between components are loaded into the computer platform 10, the computer platform 10 is formed and ready for processing.

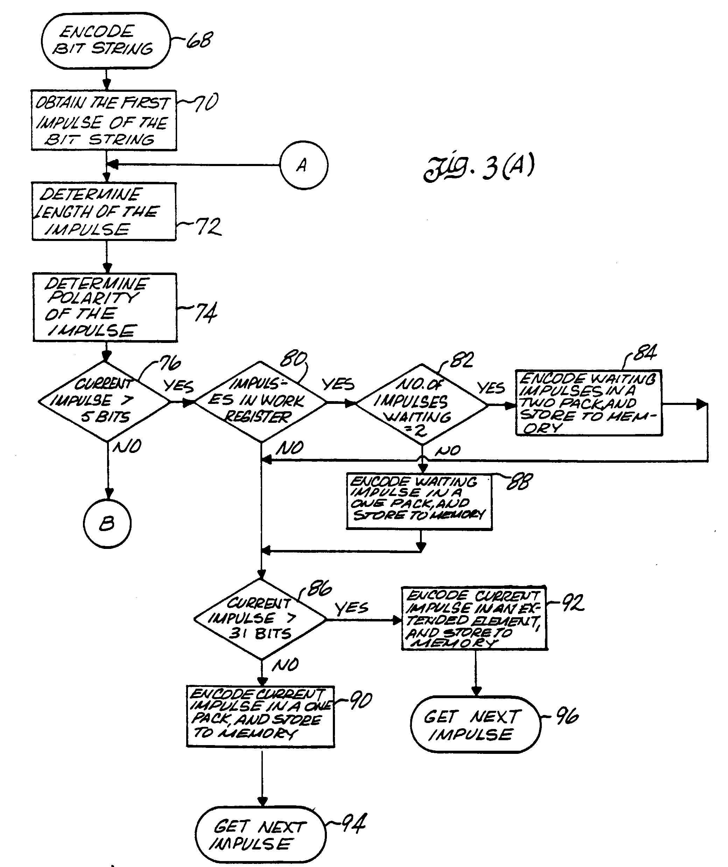

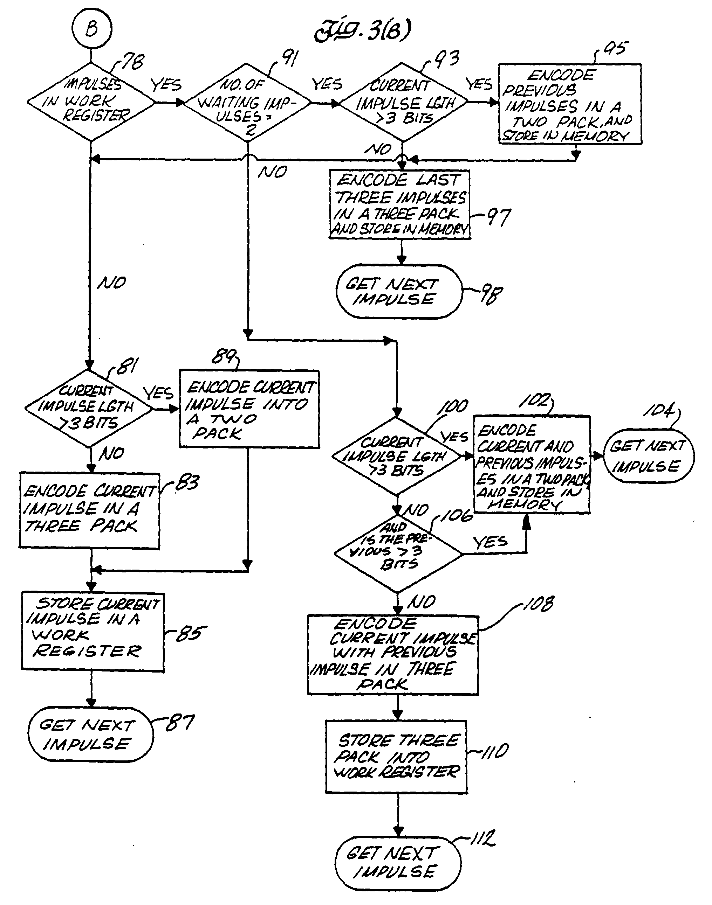

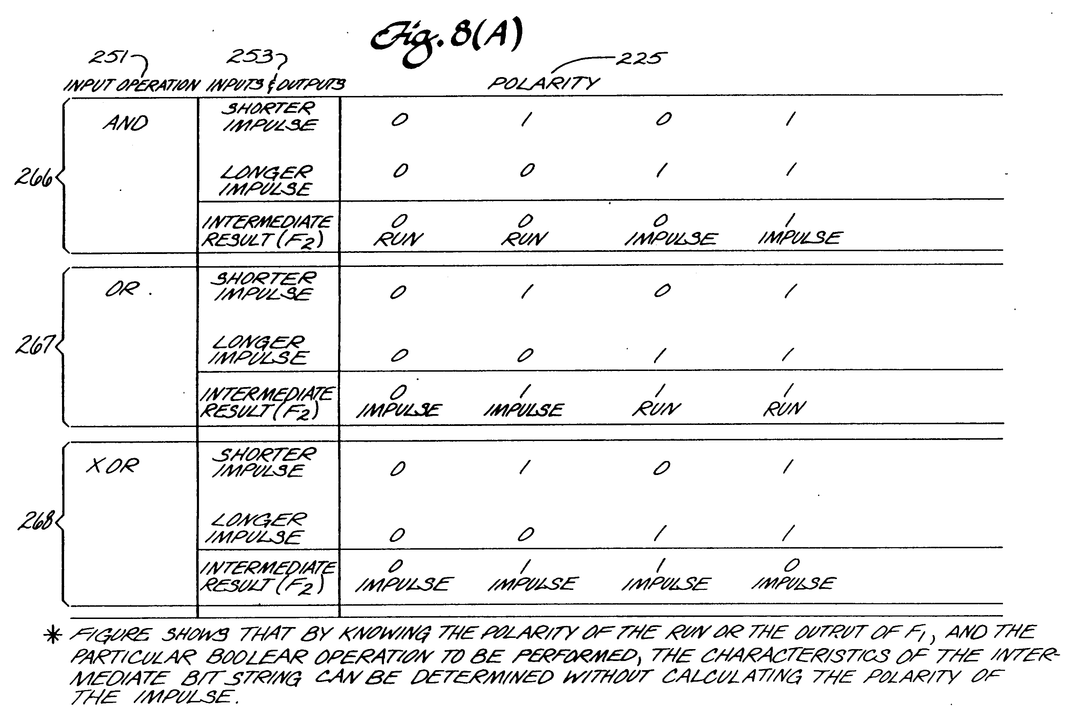

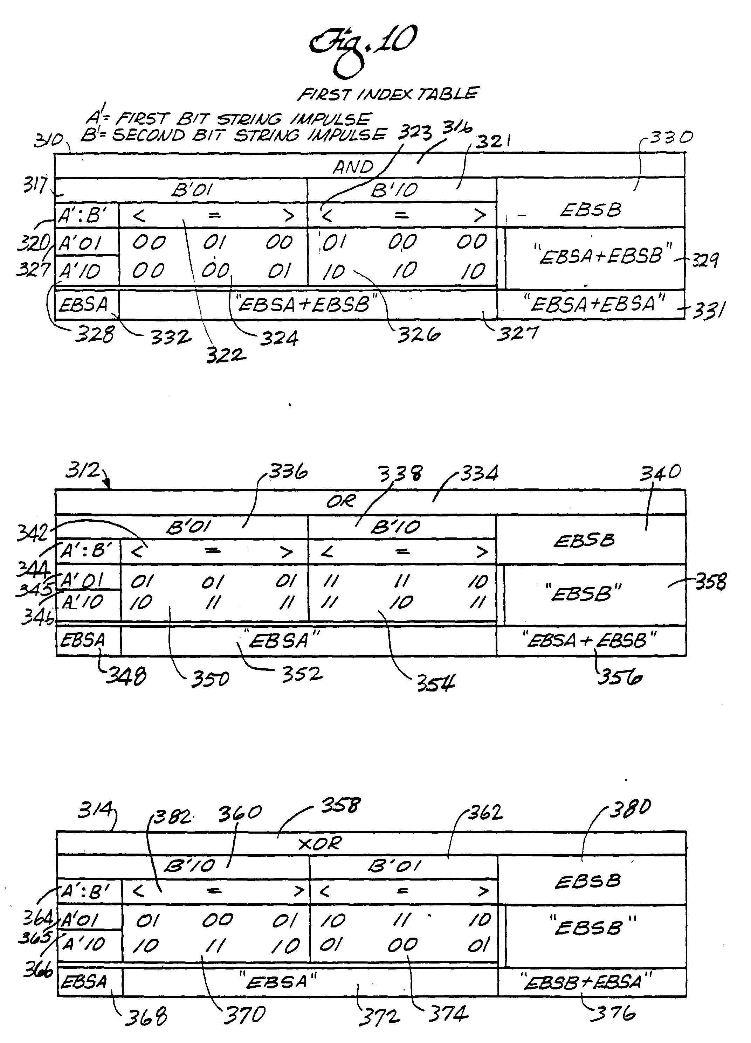

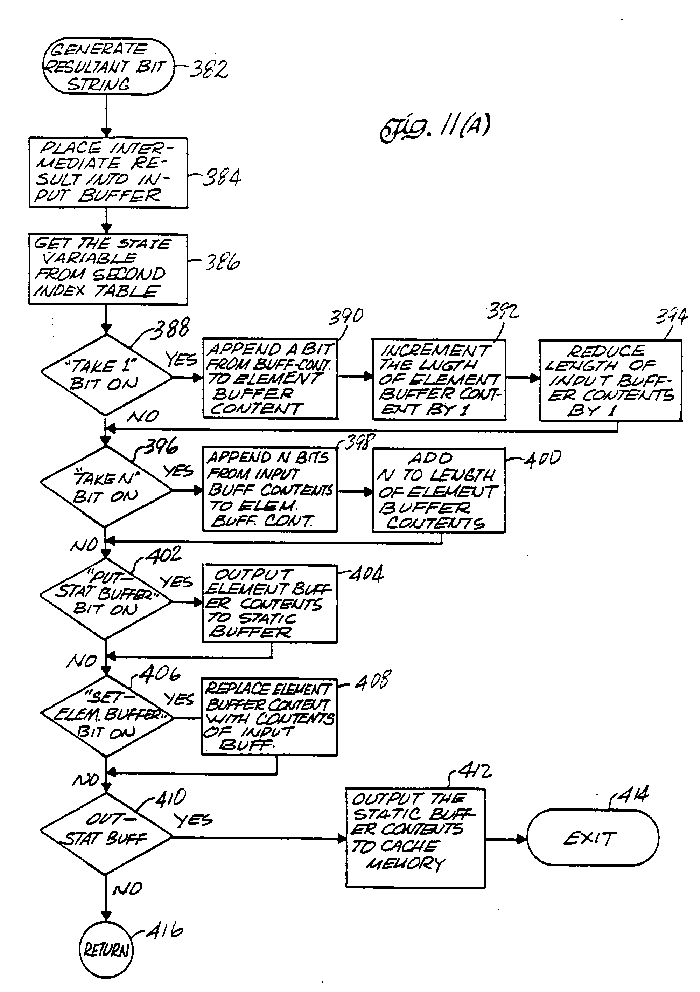

A detailed discussion of the specific components of computer platform 10 is now presented. External device 12 is a permanent or buffer storage, typically a hard disk, for uncompressed bit strings. The bit strings are representative of data which may be organized in a relational database or unorganized data acquired by satellite communications from outer space, etc. The contents of the external device 12 is loaded by bus 13 to the computer platform 10 and into encoder 14. Encoder 14 evaluates the uncompressed bit strings and separates the bit strings into one or more "impulses". An impulse is a run, which is a string of one or more bits of a same binary value or polarity (e.g., "0's" or "1's"), and an ending bit which has a polarity opposite the polarity of the run. Flow diagrams 3A, 3B, and 3C (to be discussed) depict routines executed by encoder 14 for encoding the bit strings into one of four different compressed impulse formats (FIGS. 2A, 2B, 2C and 2D). Secondary memory 16 is optional; it stores the encoded bit strings for future Boolean operations. Secondary memory 16 may be a memory component included in the host computer or a memory component included within the computer platform 10. Buffer memory 18 is another memory area for holding the encoded bit strings temporarily before processing the bit strings at the BLU 20 or before storing the bit string into the secondary memory 16 after processing. BLU 20 performs Boolean operations on two bit strings by processing a unique BLU embodiment (FIG. 10) implemented on a microprocessor (i.e. Intel 80386), or by a unique BLU hardware embodiment (FIG. 7) implemented by customized programmable logic array chips (e.g. XILINX chips). Some or all of the Boolean operations are more efficiently implemented directly in hardware. However, even if the Boolean operations are implemented primarily by software, the BLU 20 can perform the Boolean operations more efficiently in terms of storage, speed, etc., than presently known techniques for performing Boolean operations on compressed bit strings. The BLU 20 can take full advantage of the unique properties of the latest components, such as thirty-two bit microprocessor CPU's, etc.

Once an intermediate-resultant compressed bit string (intermediate bit string), which is the result of performing a Boolean operation on two impulses, has been determined by the BLU 20, it is sent via bus 21 to the canonical processor 25. The canonical processor 25 is essentially a pair of buffers for temporarily holding the intermediate bit strings until they can be combined into an impulse. When an impulse (compressed form) is generated at the canonical processor unit 25, it is output via bus 23 to buffer memory 18.

System coordinator 31 controls the processing of data on the computer platform 10. More particularly, the operation of the bus system and the operation of the components on computer platform 10 are controlled by software programs in the system coordinator 31. The dotted lines of FIG. 1A leading out from system coordinator 31 show its control over the various components. System coordinator 31 need not be a part of the computer platform 10; instead, it could be loaded into the host computer.

"00001" and "11110" are impulses which are five bits in length and may reside in a typical bit string. Both have a property of having one or more same polarity bits (e.g., "0000" or "1111") followed by a bit having a polarity opposite the same polarity bits. The polarity of the first impulse is "0" and the polarity of the second impulse is "1". The preferred formats shown in FIGS. 2A, 2B, 2C and 2D represent four compressed impulse formats for encoding one or more impulses such as the five bit impulses referred to above.

Although, throughout the specification the preferred formats start with one or more bits having the same polarity (e.g., "000" or "111") followed by a bit having a polarity opposite the same polarities, the impulses could just have easily been set up in the reverse. For example, "10000" and "01111" are impulses, which are five bits in length and they may reside in a typical bit string. Both impulses have a single bit, having a particular polarity (e.g., "0" or "1"), followed by one or more bits having an opposite polarity. Regardless of the orientation of the impulses within the bit string (i.e., "1000" or "0001"), the preferred compressed impulse format shown in FIGS. 2A, 2B, 2C and 2D represent four compressed impulse formats for including either orientations of the impulses. In the remaining portions of the specification, however, for simplicity the impulses are assumed to follow the orientation of one or more bits having the same polarity followed by an ending bit having a polarity opposite the same polarity bits (e.g., "00001").

Each of the compressed impulse formats has at least a first and a second indicator. The first indicator represents the polarity of the same polarity bits preceding the ending bit and the second indicator is for indicating the length of the impulse. The length of the impulse is the quantity of the one or more same polarity bits and the ending bit. Other impulse encoding configurations are envisioned; however, in this embodiment, each encoding scheme must have at least an indicator for depicting polarity and an indicator for representing length.

FIG. 2A represents the simplest of the four compressed impulse formats and represents a single impulse from two to 31 bits in length. Because this compressed impulse format only represents one impulse, it is labeled a "one-pack" format. Pair of bits "01" at 22 is a format designator for the "one-pack" format. Each of the impulse formats has a pair of bits for designating the particular impulse format. Bit 24 is a polarity bit "P". The polarity bit indicates whether the impulse contains a run of "1's" or a run of "0's". An impulse having a run of "1's" is a bit string of "1's" terminating in a "0" and has a polarity bit of "1", and an impulse having a run of "0's" is a bit string of "0's" terminating with a "1" bit and has a polarity bit of "0". The five bits at 26 constitute a length field "L₁L₁L₁L₁L₁". The length field specifies the length of the single impulse and it is biased by two.

The compressed format biases the length because all impulses must be at least two bits long (e.g., "01" or "10"). A length field of "00000", therefore, specifies a minimum length of two bits.

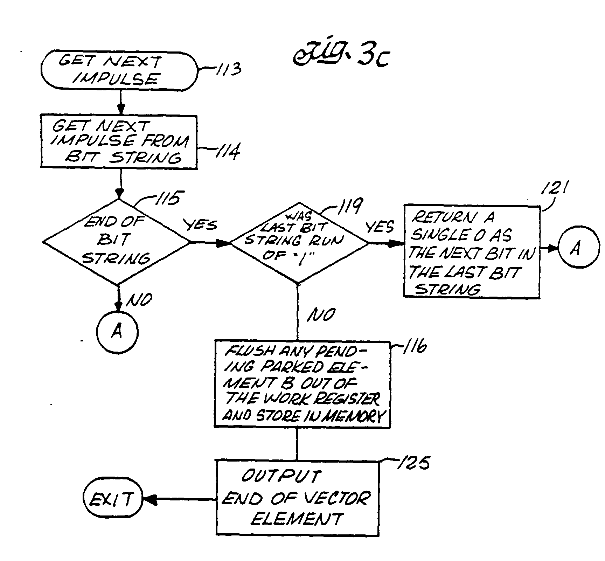

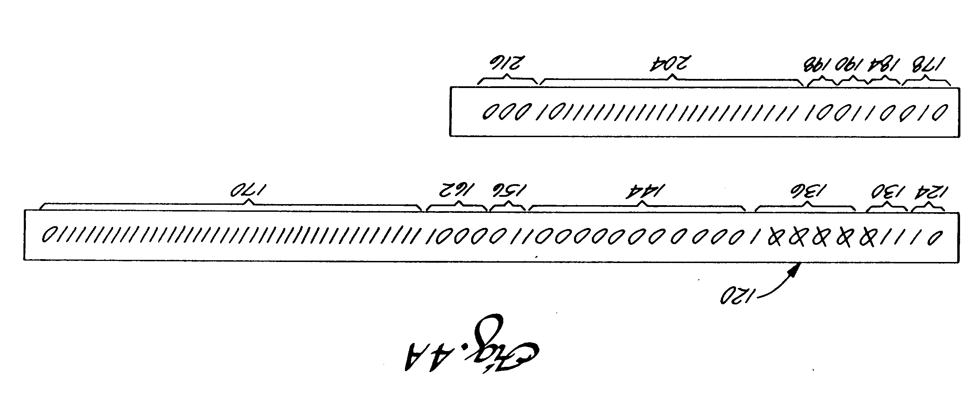

FIG. 2B depicts a compressed impulse format for representing two impulses, both impulses having a length of two to five bits, i.e. "two-pack" format. This impulse encoding format has the pair of format designator bits 28 set at "10". Polarity bits "P₁" at 30 and "P₂" at 32 are for indicating the polarity of the first and second impulses, respectively. Length fields "L₂,L₂" at 34 and "L₁,L₁" at 36, represent the length of the second and first impulses, respectively. As in the case of the "one-pack" format previously discussed, the bit length fields "L₂,L₂" 34 and "L₁,L₁" 36 are biased by two so that a length field "00" indicates an impulse of two bits while a length field of "11" indicates an impulse length of five bits. As shown in FIGS. 2A and 2B, both the first and second formats are identical in length (eight bits long) and similar in configuration. In fact, length fields "L₂,L₂" 34 and "L₁,L₁" 36 have been strategically located in the format so that the two-pack format can be easily converted into a one-pack format and vice versa. For example, if the system is attempting to fill a two-pack format with a first impulse having five bits and it turns out that the next impulse evaluated by the system encoder 14 is an impulse length greater than five bits, then the encoder can convert the two-pack format into a one-pack format by changing the format designator 28 from "10" to "01" and placing a "0" in "P₂" 32 and "0's" in "L₂,L₂" 34. The result is a one-pack format encoded for a five bit impulse. The efficiency for this encoding scheme will become more apparent after the detailed discussion of flow diagrams FIGS. 3A, 3B and 3C.

FIG. 2C is a compressed impulse format called the "three pack" format for representing three impulses of two or three bits in length, and includes a pair of format designator bits "11" at 38. Polarity bits "P₁" ' at 40, "P₂" at 42, and "P₃" at 44 depict the polarity of the first, second and third impulses. Length fields "L₁" at 50, "L₂" at 46, and "L₃" at 48 represent the length for the first, second, and third impulses respectively. For migration purposes, the actual order of the length field is "L₂" at 46, "L₃" at 48 and L₁" at 50. Once again, as in the case of the one- and two-pack formats, the length of bit indicator is biased by two. Thus, if the length bit is "0", the impulse length is two bits and if the length bit is "1", the impulse length is three bits. The three-pack also has a similar configuration to the two- and one-pack formats. Specifically, the three-pack format is identical in length (eight bits) and similar in configuration. In fact, the three-pack format can easily migrate between the two- and one-pack configurations and vice versa. For example, when the encoder 14 (FIG. 1A) encounters an impulse of two or three bits in length, it will try to fill a three-pack first so that in the event there are other impulses having lengths two or three bits, they can be efficiently encoded into the three-pack format. In the event that the next impulse length to be encoded is greater than three bits, the three-pack format can be easily converted into a two-pack or a one-pack configuration depending upon the length of the next impulse. For example, suppose the first impulse encountered has a length of two bits, then the length field "L₁" at 50 will have a "0" placed in it, representing a biased length of two bits. Now assume that the next impulse encountered is three bits in length, length field "L₂" at 46 will have "1" placed in it, indicating the next impulse having a three-bit length. However, if the length of the third impulse encountered is greater than three bits, the encoder 14 will convert the three-pack into a two-pack by changing the format designator 38 to "10" indicating the two-pack format. Thus, a three-pack format is easily converted into a two-pack format for depicting a first impulse having a two-bit length and a second impulse having a three-bit length. Likewise, the three-pack can be similarly converted into a one-pack. The configurations of the one-, two- and three-pack formats maximize the efficiency for encoding by accommodating impulses having lengths between 2 and 33 bits.

FIG. 2D is a compressed impulse format for encoding impulses with bit lengths between two bits and up to 2³²-1 bits called the "extended element". Additionally, this compressed impulse format is used for indicating an end-of-bit-string condition or a continuation of a bit string to another bit string segment to another bit string segment at a different location within memory. Included are a pair of format designator bits "00" 52 for this impulse format, polarity bit "P₁" at 54, and bits "RRR" at 56 are bits for indicating the end-of-bit-string condition or the merging utility (to be further discussed). Length fields "L₁L₁L₁L₁L₁L₁L₁L₁" 60, "L₂L₂L₂L₂L₂L₂L₂L₂" 62, "L₃L₃L₃L₃L₃L₃L₃L₃" 64 and L₄L₄L₄L₄L₄L₄L₄L₄ 65 are eight bit words for encoding the length of a particular impulse. Whether all four, three, two or one length field is required for representing an impulse is designated by a pair of bits "NN" 58. The length field "L₁L₁L₁L₁L₁L₁L₁L₁" 60 encodes impulses having lengths from two to 2⁸-1 bits. If the length of an impulse is more than 2⁸-1 bits, but less than or equal to 2¹⁶-1bits, then two length fields "L₁L₁L₁L₁L₁L₁L₁L₁" 60 and "L₂L₂L₂L₂L₂L₂L₂L₂" 62 are required for encoding. This extended element format can encode impulses of length 22 to 2¹⁶-1 bits. Three length fields 60, 62 and 64 are required if the extended element format is to encode an impulse of length 32 to 2²⁴-1 bits and all four length fields 60, 62, 64 and 65 are required if the extended element format is to encode an impulse of length 32 to 2³²-1bits.

Bits "RRR" 56 contain "0's" when the extended element format is used to encode impulses. However, when bits 56 are set to "1", the first word of the extended element format acts as an end-of-bit-string indicator. An end-of-bit-string condition indicates that there are no more bits in the bit string. Assuming that the bits "RRR" 56 are set to "1", when the first word of the extended element has the following bit pattern, "00111111", an end-of-bit-string condition exists. Similarly, when the first word of the extended element is a bit string "00111110", the extended element represents that the bit string segment has reached the end of a memory container and the next bit string segment continues on a next logical memory container.

Referring to FIGS. 3A, 3B and 3C, a detailed description of the operations of the encoder 14 is now discussed. Encoder 14 (FIG. 1A) follows the steps set forth by the routine ENCODE BIT STRING at block 68 (FIG. 3A) to direct encoder 14 in how to convert an incoming uncompressed bit string into a compressed bit string. The encoder 14 encodes the bit string at the time it is loaded into the computer platform 10 (FIG. 1A) over bus 13. In block 70, the first impulse of the bit string is obtained, and in block 72, the length of the impulse is determined by counting the number of same polarity bits and the ending bit of the impulse. In block 74, the polarity of the impulse is determined by evaluating the polarity of its run, and in block 76, a determination of whether the impulse is greater than five bits in length is made.

Assuming that the impulse acquired is greater in length than five bits, block 80 is entered to determine if there are any impulses residing in a three- or a two-pack format in a work register 9, which resides in encoder 14 (FIG. 1A). The purpose of work register 9 is to temporarily store two- and three-pack formats which are partially filled with one or two impulses. Assuming that there are impulses residing in the work register 9 then in decision block 82, a determination is made as to how many impulses are present in work register 9. If the number of impulses waiting is two, then the format configuration must be a three-pack format. In other words, two impulses are waiting for a third impulse to fill the three-pack format. Because the current impulse is greater in length than five bits, it will not fit into the three-pack configuration, and thus, the three-pack format is changed into a two-pack format (as discussed above) at block 84. The two waiting impulses now reside in a two-pack format and the contents of the work register 9 is stored in memory 16. Processing continues at block 86.

Returning back to block 80, if it is determined that no impulses occupy the work register 9, then the current impulse will be evaluated. In either case, the current impulse will then be evaluated at block 86 to determine if the current impulse length is greater than 31 bits. Assuming that the length of the current impulse length is not greater than 31 bits, then in block 90, the current impulse is represented in a one-pack configuration and in block 94, subroutine GET NEXT IMPULSE (FIG. 3C) is called for retrieving the next impulse of the uncompressed bit string. If in block 86 the encoder determines that the current impulse length is greater than 31 bits, then in block 92 the encoder converts the current impulse into the extended element format and in block 96 the GET NEXT IMPULSE routine (FIG. 3C) is called for retrieving the next impulse of the uncompressed bit string.

Returning to decision block 82, if only one impulse resides in the work register, the impulse must be between two and five bits and currently encoded in either a two-or three-pack configuration. In either case, assuming that the waiting impulse length is greater than five bits, in block 88, the two- or three-pack formats will be converted into a one-pack format and the contents of work register 9 is stored in memory 16. The current impulse is then checked, at decision block 86, to determine whether it is greater in length than 31 bits. If the current impulse length is not greater than 31 bits, block 90 is entered and the current impulse is converted into a one-pack format and the current encoded impulse is stored in memory 16. In block 94 the GET NEXT IMPULSE routine (FIG. 3C) is called to get the next impulse of the uncompressed bit string. However, if the current impulse length is greater than 31 bits, in block 92, the current impulse is converted into an extended element format and the current encoded impulse is stored in memory 16. In block 96 the GET NEXT IMPULSE routine (FIG. 3C) is called to get the next element of the uncompressed bit string.

Referring back to block 76, when the current impulse length is not greater than five bits, decision block 78 (FIG. 3B) is entered to determine whether there are any impulses waiting to be processed in work register 9 (FIG. 1A). Assuming that there are no impulses waiting to be processed in the work register, decision block 81 is entered to determine whether the current impulse length is greater than three bits. Assuming that the current impulse length is not greater than three bits, block 83 is entered to put the current impulse into a three-pack format. In block 85, the three-pack is stored into work register 9 (FIG. 1A) so that the three-pack can be filled with two other impulses having two or three bits, or until the three-pack is converted into a two-pack or a one-pack. Routine GET NEXT IMPULSE (FIG. 3C) is called in block 87 to get the next impulse in the uncompressed bit string.

Referring back to block 81, if encoder 14 determines that the impulse length is greater than three bits, block 89 is entered to encode the current impulse into a two-pack format. At this stage, the encoder has determined that the current impulse length is not greater than five bits (at block 76) and that the impulse length is greater than three bits (at block 80). Thus, the impulse must fit into the two-pack format because it is either four or five bits long. In block 85, the two-pack is stored into the work register, and in block 87, routine GET NEXT IMPULSE (FIG. 3C) is called to obtain the next impulse in the uncompressed bit string.

Returning to decision block 78, if there are impulses waiting to be processed in work register 9 (FIG. 1A), decision block 91 is entered to determine how many impulses are waiting in the work register. If there are two impulses waiting to be processed, decision block 93 is entered to determine whether the current impulse length is greater than three bits. If the current impulse length is not greater than three bits, block 97 is entered to encode the current impulse, along with the waiting impulses, into a three-pack and store the three-pack into memory 16. In block 98, the GET NEXT IMPULSE routine (FIG. 3C) is called to obtain the next impulse in the uncompressed bit string.

Returning to block 93, if the current impulse is greater than three bits, block 95 is entered to encode the previous impulses into a two-pack and store the encoded two-pack into memory 16. Processing continues at block 81. During block 81, if encoder 14 determines that the current impulse is greater than three bits, block 89 is entered to encode the current impulse into a two-pack format. At this stage, the encoder has determined that the current impulse is not greater than five bits (at block 76) and that the impulse is greater than three bits (at block 80). Thus, the impulse must fit into the two-pack format because it is either four or five bits long. In block 85, the two-pack format is stored into the work register, and in block 87, routine GET NEXT IMPULSE (FIG. 3C) is called to obtain the next impulse in the uncompressed bit string.

Returning to decision block 78, if there are impulses waiting in the work register, and in decision block 91 the encoder determines that there is only one impulse waiting (e.g., in a two-pack) in work register 9, block 100 is entered to determine if the current impulse length is greater than three bits. If the current impulse length is greater than three bits, block 102 is entered to encode the current impulse and the waiting impulse into the two-pack format and to store the encoded impulses into memory 16. In block 104, the GET NEXT IMPULSE routine (FIG. 3C) is called to obtain the next impulse in the uncompressed bit string.

Returning to decision block 100, if the current impulse length is less than or equal to three bits, then decision block 106 is entered to determine if the length of the waiting impulse in work register 9 is also less than or equal to three bits. If the waiting impulse length is greater than three bits, block 102 is entered to place the current impulse and the waiting impulse into a two-pack and to store the encoded impulses into memory 16. In block 104, the GET NEXT IMPULSE routine is called to obtain the next impulse in the uncompressed bit string. If in decision block 106 it is determined that the waiting impulse length is less than or equal to three bits, then in block 108 the current impulse and the waiting impulse are placed into the three-pack format already existing in work register 9. In block 110, the three-pack format containing the current impulse and the waiting impulse are stored into work register 9 (FIG. 1), and in block 112, the GET NEXT IMPULSE routine is called to get the next impulse in the uncompressed bit string.

FIG. 3C is a detailed flow diagram depicting the GET NEXT IMPULSE routine. Encoder 14 calls this routine at block 113 (FIG. 3C), and in block 114 the next group of bits from the uncompressed bit string is acquired. Decision block 115 is entered to determine whether there are bits remaining in the bit string by having encoder 14 evaluate whether there is an end-of-bit-string condition. If an end-of-bit-string condition is not reached, then processing returns to the ENCODE BIT STRING routine (FIG. 3A) in block 72. However, if an end-of-bit-string condition is reached, block 119 is entered to determine if remaining bits in the uncompressed bit string are a run of "0"s or no bits or a run of "1"s. Assuming that there are no bits remaining in the bit string or the bits are "0", block 116 is entered to flush out the remaining impulse in work register 9 to memory and block 125 is entered to encode an element to signify an end-of-bit-string condition. In block 118 an EXIT routine is called which returns processing to the original calling routine of the ENCODE BIT STRING routine (FIG. 3A).

Assuming that in decision block 119 it is determined that there is a run of "O's" remaining in the bit string, block 116 is entered to flush out the work register and block 125 is entered to encode the extended element to signify an end-of-bit-string condition. Block 118 is called to have the encoder exit to the calling routine. This procedure, performed by the encoder in block 125, effectively truncates the run of "0's" from the bit string by not encoding the bits into one of the compressed impulse formats.

On the other hand, if the remaining bit(s) are a run of "1's", block 121 is entered to append a "0" to the run of "1's". A "1" bit signifies that data exists at that particular bit location, and thus, it must be preserved. Essentially, in block 121, the encoder converts the run of "1's" into an impulse having polarity "1" so that it can be conventionally converted into the one-pack or extended element format. Adding a "0" to the run of "1's" adds no additional information to the run of "1's" for the reasons stated above and it will not require any additional bits for encoding. Processing returns to FIG. 3(A) to encode the new impulse into a one-pack or an extended element format depending on the size of the impulse (i.e., impulses of from two to 31 bits in length are encoded into a one-pack and impulses of from 32 and 2³²-1 bits are encoded into an extended element).

As the entire bit string is compressed into the encoded format it is stored in memory 16 where it will reside until future processing.

### A. Example Of Converting Uncompressed Bit Strings Into Compressed Bit Strings

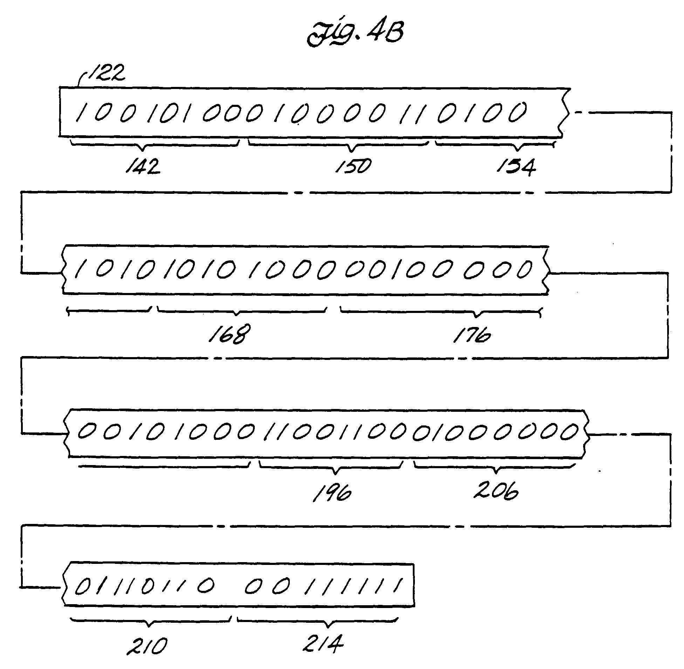

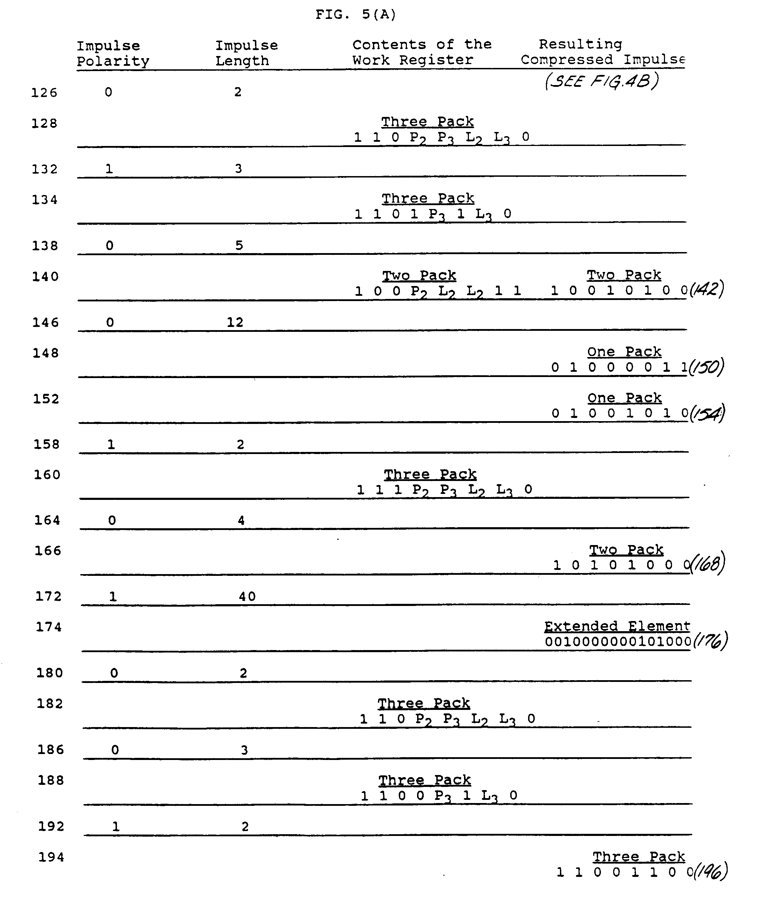

Referring to FIGS. 2A, 2B, 2C, 2D; 3A, 3B, 3C; 4A, 4B; 5A and 5B, a detailed example for converting an uncompressed bit string into a compressed bit string is discussed. Referring to FIG. 4A, a hypothetical uncompressed bit string 120 is shown. After the compression operation is performed by encoder 14, a compressed bit string is generated as shown at 122 of FIG. 4B. This example has been designed to emphasize all of the compressed impulse formats as shown in FIGS. 2A, 2B, 2C and 2D and the encoding processes as shown in FIGS. 3A, 3B and 3C. In this example, the compression of the uncompressed bit string 120 (FIG. 4A) into the compressed bit string 122 (FIG. 4B) results in a 25% reduction of bits. Specifically, the uncompressed bit string has 107 bits and the resulting compressed bit string has 80 bits. Typically, in many database setting, the run lengths in a bit string are of much greater lengths and, thus, the efficiency for compressing an uncompressed bit string is significantly enhanced.

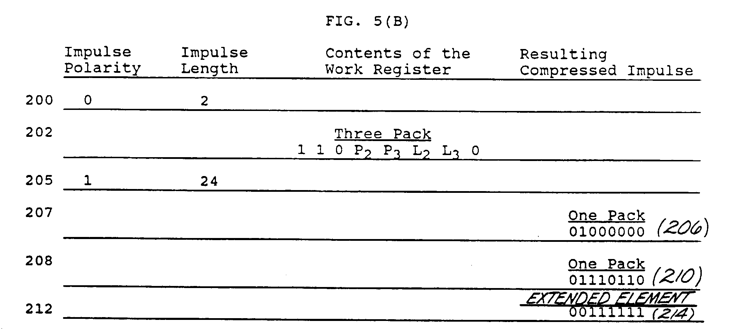

The uncompressed bit string 120 (FIG. 4A) is taken from the external device 12 (FIG. 1A) and is sent to the encoder 14 (FIG. 1A); where it is converted into a compressed bit string 122. The activities associated with processing the encoder 14 are depicted in the results table of FIGS. 5A and 5B. The results table of FIGS. 5A and 5B is divided into four columns, one for the impulse polarity, a second for the impulse length, a third for the contents of work register 9 (FIG. 1A), and a fourth for the resulting compressed impulse format. Each row depicts a change in status in one or more of the column headings.

The uncompressed bit string 120, as shown in FIG. 4A, is divisible into a sequence of impulses 124, 130, 136, 144, 156, 162, 170, 178, 184, 190, 198, 204 and 216. It will be noted that each impulse extends for one or more bits of one polarity followed by a single bit of the opposite polarity. The resulting compressed bit string 122, as shown in FIG. 4B, comprises a series of eight bit (or multiples of eight bit) words in the one-pack, two-pack, three-pack, and extended length formats, as indicated at 142, 150, 154, 168, 176, 196, 206, 210, and 214. FIGS. 5A and 5B summarize the steps required to generate each compressed format of FIG. 4B from the polarity and length of the impulses of the bit string of FIG. 4A, following the steps shown by FIGS. 3A-C.

### II. OPERATIONS ON BIT STRINGS

Referring to FIGS. 1A, 4A and 4B, as the encoder 14 converts the uncompressed bit string 120 (FIG. 4A) into the compressed bit string 122 (FIG. 4B), the compressed bit string 122 is stored in the secondary memory 16 of computer platform 10 (FIG. 1A). The bit string stored in secondary memory 16 may be representative of compressed data of many types. This information can be manipulated by performing Boolean operations directly on the bit strings representative of the data stored in secondary memory 16. The remaining portion of this disclosure centers on the unique process of performing Boolean operations at BLU 20 on the compressed bit strings stored in secondary memory 16. By being able to perform Boolean operations on the compressed bit strings, substantial savings in time and memory space are achieved. Time saving occurs because the encoded bit strings need not be decompressed to their original form when performing the Boolean operations. Additionally, through the use of unique hardware and/or software, the Boolean operations on the bit strings are more efficiently processed. Memory savings occur because the bit strings which result from the Boolean operations are maintained in a compressed form.

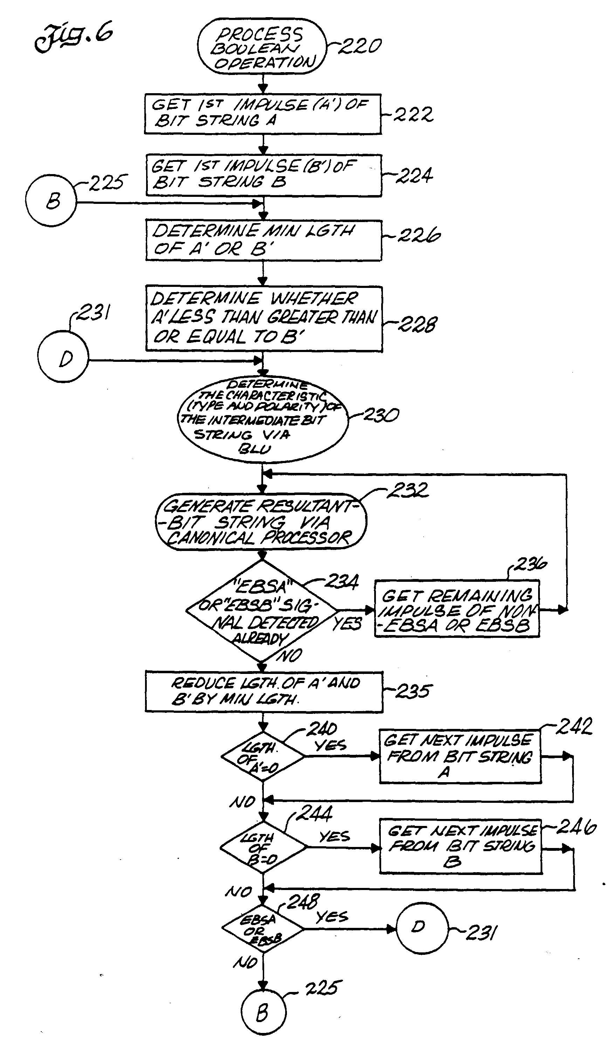

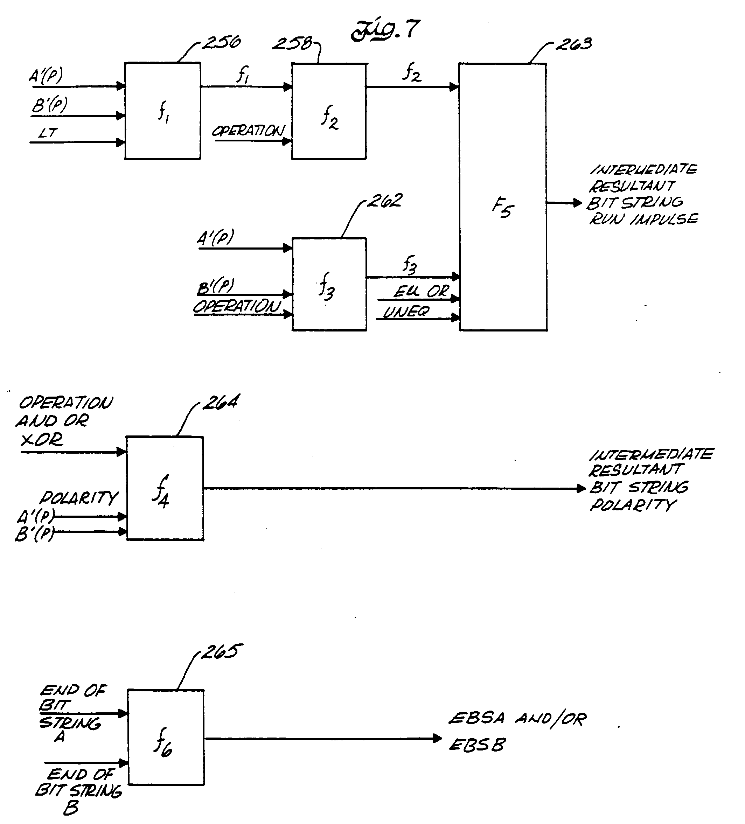

Only the primary Boolean operations AND, OR and EXCLUSIVE OR shall be discussed in detail. Even though the discussion is limited to the primary operators, it is envisioned that all 16 Boolean operations can be implemented by the BLU 20 within the scope of the appended claims. The coordination of the BLU 20 (FIG. 1A) with other components of the computer platform 10 is performed by a routine PROCESS BOOLEAN OPERATION (FIG. 6) executed by system coordinator (31, FIG. 1A). The system coordinator 31 (FIG. 1A) oversees processing of the Boolean operations on two bit strings and oversees canonical processing of the intermediate results generated by the BLU 20. There are two embodiments of the BLU 20, the first is a special purpose Boolean hardware configuration (FIG. 7), and the second is a Boolean software configuration, a portion of which can be implemented by an index table (FIG. 10).

Referring to FIG. 1A, when a request for processing a Boolean operation on two particular bit strings is made, the bit strings are retrieved from secondary memory 16 and sent via bus 17 to buffer memory 18. The bit strings remain in their encoded compressed form and are loaded to the BLU via bus 19 upon request by the BLU 20. BLU 20 performs the particular Boolean operation specified and intermediate results are tabulated and buffered (stored) at canonical processor 25 (FIG. 1A). When the processing of the bit strings is completed, the resulting compressed bit string is sent via bus 23 to buffer memory 18, where it resides until it can be output to secondary memory 16. This process of moving data via the buses to the various components of the computer platform 10 (FIG. 1A) is controlled by the system coordinator (31, FIG. 1A).

FIG. 6 is a detailed flow diagram of the PROCESS BOOLEAN OPERATION routine which is executed by the system coordinator 31 (FIG. 1A). This routine initiates the Boolean hardware or software embodiments of BLU 20 (FIG. 1A) as shown in FIGS. 7 and 10 and the routine initiates the canonical processor 25 (FIG. 1A). A more detailed discussion on the canonical processor (25, FIG. 1A) is presented in Section D. In block 222 (FIG. 6) a first impulse A' is obtained from a first bit string A residing in the buffer memory 18 (FIG. 1A). In block 224 the first impulse B' of the second bit string B is also obtained from buffer memory 18 (FIG. 1A). The minimum length of either impulse A' or B' is determined in block 226. The minimum length is the length of an intermediate bit string determined by processing impulse A' with impulse B'. In block 228 encoder 14 determines whether the length of impulse A' is less than,'greater than, or equal to, impulse B' and in block 230 the Boolean special purpose hardware (FIG. 7) or the Boolean index table (FIG. 10) determines the characteristics of the intermediate bit string; whether the intermediate bit string is an impulse or run with polarity "0" or "1". Due to the unique structure of the compressed impulse formats, (FIGS. 2A, 2B, 2C and 2D) the Boolean operations can be performed very efficiently. This feature of the present invention will be discussed in more detail.

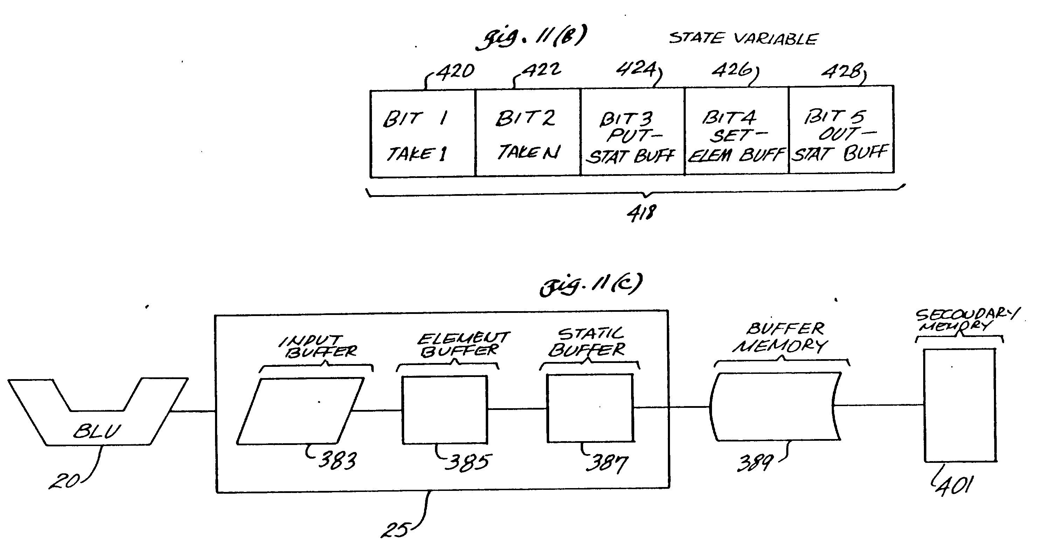

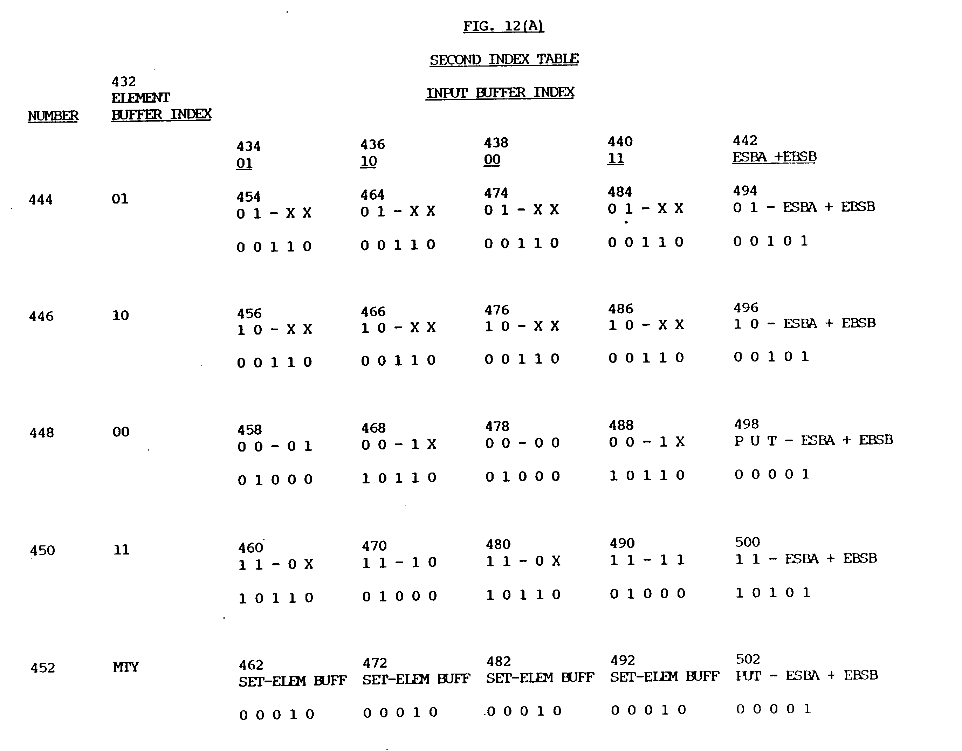

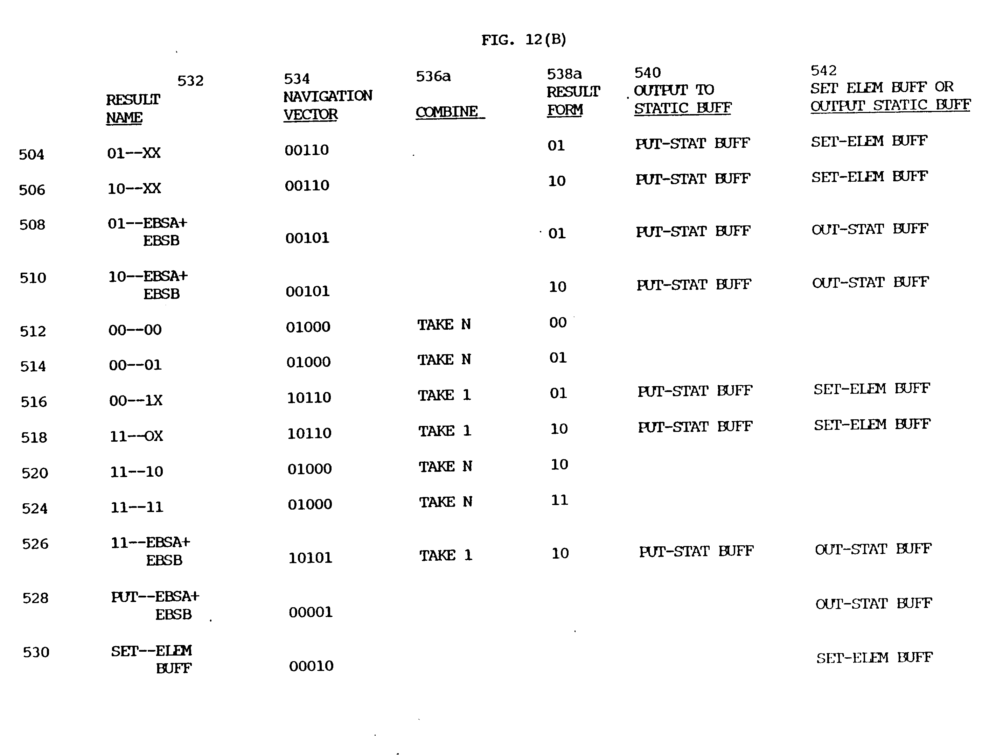

The intermediate bit string determination by the BLU in block 230 is then input to the canonical processor 25 (FIG. 1A) via subroutine GENERATE RESULTANT BIT STRING at block 232 (FIG. 11A). This subroutine generates one of 8 different state variables (FIG. 11B), which are indexed in a second index table (FIG. 12A) and enumerated in FIG. 12B, to convert the intermediate bit string results into one or more impulses. A detailed discussion on these subroutines will also be presented.

In decision block 234, a determination of whether an end-of-bit-string condition has occurred in either bit string A and/or the bit string B is made. An end-of-bit-string condition indicates that there are no more impulses in the bit string to be processed by the BLU. If an end-of-bit-string condition has occurred in one of the bit strings, then during block 236 the next impulse from the bit string which does not have an end-of-bit-string condition is obtained. Processing returns to the GENERATE RESULTANT BIT STRING routine (FIG. 11A) in block 232 which processes the next impulse obtained by block 236. Blocks 236, 232 and 234 are entered until no more impulses reside in the bit string. Assuming that neither one of the bit strings has an end-of-bit-string condition, block 235 is entered to reduce the length of impulse A' and the length of impulse of B' by the minimum length determined in block 226. This step accounts for the bits which have been processed by the BLU in block 230.

In decision block 240 a determination is made whether the length of impulse A' has been reduced to zero. If the length of impulse A' has been reduced to zero, then in block 242 the next impulse A' is obtained from the bit string A. Assuming that the length of A' has not been reduced to zero, or when block 242 has finished processing, decision block 244 will be called to determine whether impulse B' has been reduced to zero. If impulse B' has been reduced to zero, block 246 is entered to get the next impulse B' from the bit string B. If impulse B' has not been reduced to zero, or when block 246 is finished processing, block 248 will be entered to determine if an end-of-bit-string condition has been reached in bit string A and/or bit string B. This step is performed to analyze the condition of the bit strings after the reduction of the minimum length from the two impulses A' and B' in block 235. Assuming that neither bit string has reached an end-of-bit-string condition, processing will return to block 226 of FIG. 6 to continue processing the newly obtained impulse(s) in either block 242 or in block 246 with the remainder of the other impulse, if necessary.

Returning to decision block 248, if an end-of-bit-string condition is reached in bit string A or bit string B or both, then block 230 is entered to determine how to most efficiently perform the current Boolean operation on the bit string having the remaining impulses. More particularly, block 230 outputs a signal which directs the GENERATE RESULTANT BIT STRING routine (FIG. 11A) how to most efficiently generate the resultant bit string without actually performing the Boolean operation. Essentially, if the end-of-bit-string condition has been reached in both bit strings, processing ends in the GENERATE RESULTANT BIT STRING routine (FIG. 11A) because there are no more impulses on which to perform the Boolean operation. However, if there are remaining impulses in either bit string, depending on the Boolean operation, either blocks 232, 234 and 236 are performed to generate a resultant bit string, or processing automatically exits in the GENERATE RESULTANT BIT STRING routine (FIG. 11A). (A more detailed discussion will be provided with FIGS. 7 and 10.)

Returning to blocks 226, 228 and 230 of FIG. 6, a more detailed description of the apparatus and method for determining an intermediate resultant bit string is now discussed. As stated above, block 226 determines the minimum length of two impulses obtained from the bit strings in buffer memory 18 (FIG. 1A). The minimum length will always be the length of the intermediate bit string because only the bits of the minimum length impulse will be processed against the corresponding bits of the longer impulse in the determination of the intermediate bit string. Thus, the longer impulse will always have remaining unprocessed bits. Additionally, the bits which are processed in the longer impulse will always be either a run of "1's" or a run of "0's". If the two impulses A' and B' are of equal length, the intermediate bit string length will be the length of either impulse A' or impulse B'. Block 228 determines whether the length of impulse A' is less than, equal to, or greater than the length of impulse B'. This information determined in block 228 will be used by the hardware or software implementations in FIGS. 7 and 10 during block 230. With the length of the intermediate bit string calculated in block 226, only the characteristics of the intermediate bit string need to be determined, i.e., whether the intermediate bit string is a run of "1's" or "0's" or an impulse having a polarity of "1" or "0". Block 230 (hardware or software embodiments) efficiently calculates these characteristics of the intermediate bit string.

### A. Hardware Embodiment for Performing BOOLEAN Operations on Compressed Impulses

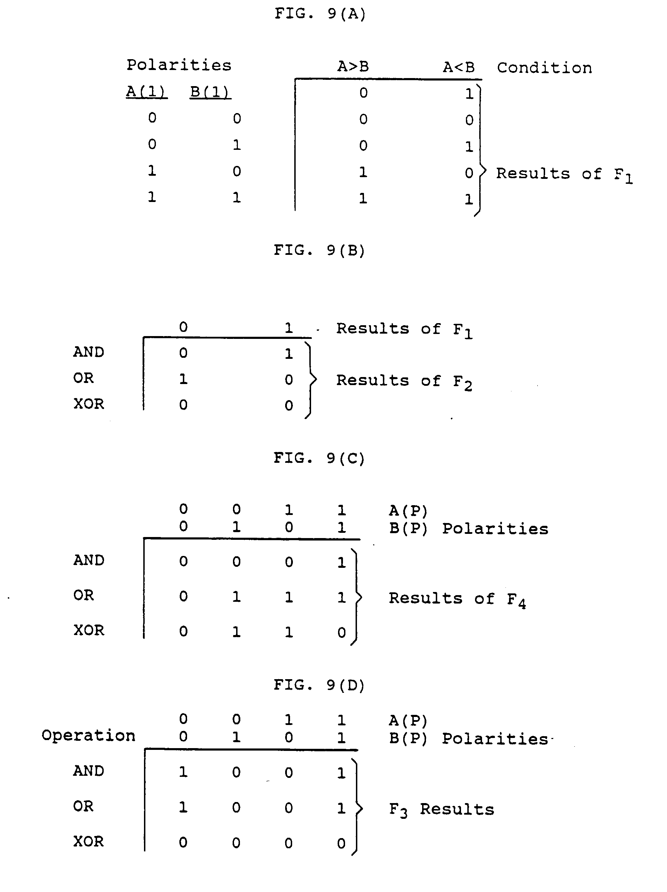

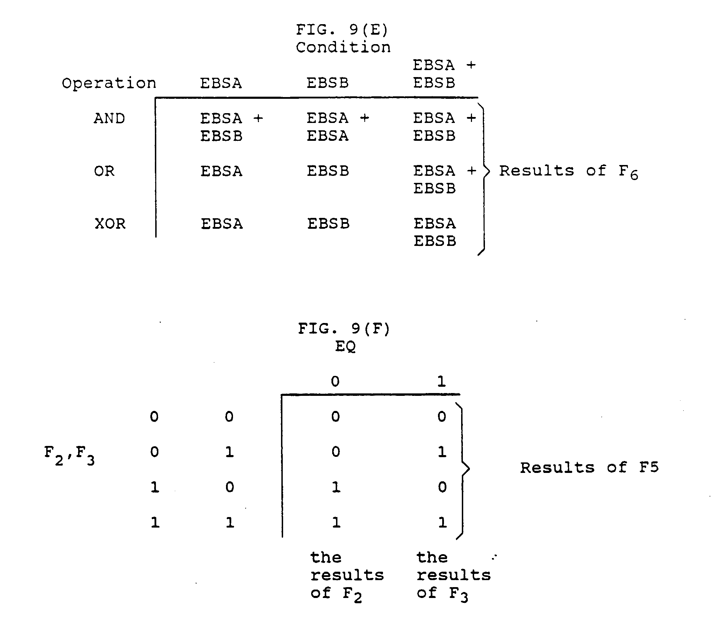

The preferred embodiment of Boolean hardware for calculating the characteristics of an intermediate bit string is shown in the schematic block diagram in FIG. 7. FIG. 7 depicts the flow of information. The actual inputs and outputs for each function are depicted in FIGS. 9A, 9B, 9C, 9D, 9E and 9F. A detailed discussion of its implementation is now presented. Blocks 256, 258, 260, 262, and 264 embody special purpose customizable logic array chips (e.g. XILINX chips) and each performs a particular step in performing the Boolean operation. More particularly, the purpose of hardware function F4 264 is to determine the polarity of the intermediate bit string. Hardware function F1 256, and F2 258 are for determining the type of the intermediate bit string (e.g., whether the intermediate bit string is a run or an impulse) when impulses A' and B' are of unequal lengths. Hardware function F3 262 determines the type of the intermediate bit string when impulses A' and B' are equal in length. Lastly, hardware function F6 265 determines whether an end-of-bit-string condition exists in either bit string A and/or B.

As stated, function F1 256 is performed when the lengths of impulses A' And B' are unequal. The purpose of function F1 256 is to determine the polarity of the longer impulse. The inputs to F1 256 are the polarity of impulse A' called "A'(P)", the polarity of impulse B' called "B'(P)", and the condition "LT" indicating whether the length of A' is less than the length of B' as determined in block 226 (FIG. 6). Function F1 outputs the polarity of the longer impulse, either a "0" for "0"-polarity or "1" for "1"-polarity. A truth table representing the various inputs and results of hardware function F₁ is shown in FIG. 9A. The top line of the truth table shows the LT input; whether the length of impulse A' is less than or greater than the length of impulse B'. When LT is "0", the length of impulse A' is greater than impulse B' and when LT is "1", the length of impulse A' is less than impulse B'. More particularly, if the length of impulse A' is less than B', then the column of results under "1" represents the output of F1. Likewise, if the length of impulse A' is greater than B', then the column of results under "0" represents the output of function F1. The left-hand side of the truth table depicts the polarity inputs of impulses A' and B'. For example, when the length of impulse A' is less than impulse B' and the polarity of A' and B' is "0" respectively, the polarity of the longer impulse is "0", and thus the result of F1 is "0".

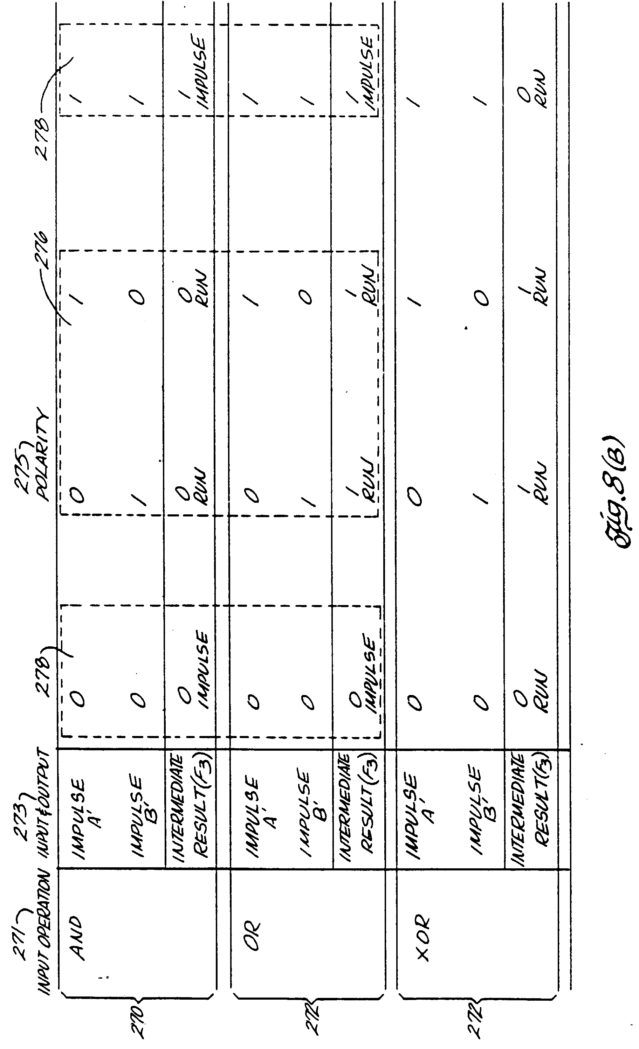

When impulses A' and B', to be processed by the Boolean operation, are unequal in length, a run (i.e., a portion of the longer impulse) is always processed against a shorter impulse. For this reason, the results of processing a run having polarity "0" or "1" against an impulse having polarity ("0" or "1") can be modeled by a hardware function and depicted in a table representation in FIG. 8A. More particularly, FIG. 8A depicts the function F2 and it shows that by knowing the polarity of the run, or the output of F1, and the particular Boolean operation to be performed, the characteristics of the intermediate bit string can be determined without calculating the polarity of the impulse.

More particularly, the table of FIG. 8A is separated into three different columns. The first column 251, on the left-hand side, names the Boolean operation to be performed by the BLU 20. The second column 253 names the inputs and outputs to F2 258 (FIG. 7), and the third column 255 depicts the polarity of the input impulse, the polarity of the input run and the polarity of the intermediate bit string result. The table is also separated into three sections, 266, 267, and 268, each corresponding to a different Boolean operation.

Referring to section 266, the results of performing the AND operation are shown. It is a property of the AND operation, when an impulse having polarity "0" or "1" processed against a run of "0's", the intermediate bit string obtained from this operation is always a run of "0's", regardless of the polarity of the impulse. This occurs because when a run of "0's" is ANDed against an impulse having a polarity of "1" or "0" it always results in a run of "0's". Likewise, a run of "1's" ANDed against an impulse having a polarity of "0" or "1" will always result in an impulse. Thus, by knowing the polarity of the longer bit string (F1) and by knowing the operation to be performed by the BLU, the characteristics of the intermediate bit string can be determined without calculating the length of the run (i.e., a portion of the longer impulse) or shorter impulse and without calculating the polarity of the impulse (i.e., shorter impulse). When the type (run or impulse) determined by F2 is a run, the F2 function outputs a "0", and when the type determined by F2 is an impulse, the F2 function outputs a "1". Thus, a truth table representation of function F2 can be created as in FIG. 9B. When the Boolean operation is an AND operation and the longer bit string is a run having a polarity of "0" (e.g., output F1), the output of F2 is a "0", or a run. The truth table of FIG. 9B, depicting the results of the F2 function 258 (FIG. 7), demonstrates an interesting property for determining the characteristics of the intermediate bit string. When the AND operation is performed, the output of the F2 function is the output of the F1 function. Additionally, when the Boolean operation is an OR operation, the output of the F2 function is simply the complement of the output of the F1 function. Lastly, when the operation is EXCLUSIVE OR, the F2 function automatically outputs a "0" without interpreting the input function F1. Thus, the hardware embodiment need only perform the following functions when the impulses are unequal in length:
F2 = F1 (operation - AND);
F2 = NOT F1 (operation - OR);
F2 = "0" (operation - EXCLUSIVE OR); where
F1 is the polarity of the longer impulse.

From these observations, three formal rules are now developed for determining an intermediate bit string when impulse A' is unequal in length to impulse B'. Rule I, when the Boolean operation is an AND operation, the polarity of the longer impulse indicates whether the intermediate bit string is a run or an impulse. More particularly, if the polarity of the longer impulse is "1" and the Boolean operation is AND, the intermediate bit string is always an impulse. Likewise, if the polarity of the longer bit string is "0" and the Boolean operation is an AND operation, the intermediate bit string is always a run. Rule II, when the Boolean operation is an OR operation, the complement of the polarity of the longer bit string indicates whether the intermediate bit string is a run or an impulse. More particularly, if the polarity of the longer bit string is "1" and the Boolean operation is an OR the intermediate bit string is always a run. Likewise, if the polarity of the longer bit string is "0" and the Boolean operation is OR, the intermediate bit string is always an impulse. Lastly, Rule III, when the Boolean operation is an EXCLUSIVE OR operation, the intermediate bit string is always an impulse, regardless of the polarity of the longer and shorter bit strings.

Once the characteristic of the intermediate bit string is determined, the polarity of the intermediate bit string is simultaneously determined by function F4 264 (FIG. 7). F4 simply performs the particular Boolean operation on the polarity of impulse A' with the polarity of impulse B'. Regardless of whether impulse A' is longer or shorter than impulse B', the polarity of the resultant intermediate bit string will always be the result of ANDing- the polarities of the two impulses. The same principle holds true for OR and EXCLUSIVE OR on impulses of equal or unequal lengths.

Referring to FIG. 9C, a truth table depiction of the results for F4 is shown. The inputs to F4 are the Boolean operations (i.e., AND, OR and EXCLUSIVE OR) and the polarity ("0" or "1") of the impulses A' and B'. (See also FIG. 7.) When the polarities of A'(P) and B'(P) are "0" and the Boolean operation is AND, the results of ANDing "0" with "0" is "0" as shown in the map FIG. 9C. The hardware implementation logically follows the truth table FIG. 9C.

To this point, the discussion regarding the Boolean hardware involved impulses A' and B' when they are unequal in length. Now, a detailed discussion is presented for processing impulses A' and B' when they are equal in length. Specifically, function F3 262 of FIG. 7 determines the intermediate result when impulses A' and B' are equal. FIG. 8B is a table depicting the intermediate bit string results of function F3. Like FIG. 8A, FIG. 8B is separated into three columns. The first column 271, in the left-hand side of the table, labels the Boolean operations to be performed by the F3 function (262, FIG. 7). The next column 273, labels the impulses A' and B' and the intermediate bit string results of the F3 function. Column 275 depicts the polarities of the input impulses and the polarities of the resulting bit strings. FIG. 8B demonstrates that when the impulses are equal in length, the characteristics of the intermediate bit string can be calculated with only knowing the polarities of impulses A' and B'. For example, if the input Boolean operation is AND and the impulses A' and B' have polarity "0", then the resulting bit string is an impulse with a polarity "0", as depicted in the table FIG. 8B. These results logically follow because the AND operation of impulses which are equal in length and have "1" bits in the same location, produces the same bit string. Likewise, when the impulse A' has a polarity of "0" and the impulse B' has a polarity of "1" and the Boolean operation is AND, the intermediate bit string is a run of "0's".

The results depicted in FIG. 8B suggests the following formal set of rules: Rule I, when the Boolean operation is either an AND or an OR operation, and when the polarity of the impulses A' and B' are different, the intermediate bit string is a run. This property is shown in box 276 of FIG. 8B. Rule II, when the Boolean operation is either an AND or an OR operation, and when the polarity of impulse A' and impulse B' are the same, the intermediate bit string is an impulse as shown in box 278 of FIG. 8B. Lastly, when the Boolean operation is EXCLUSIVE OR, it doesn't matter what the polarity of impulses A' and B' are, the result will always be a run as shown in box 280 (FIG. 8B).

The results of function F3 can be represented in a truth table as shown in FIG. 9D. When the result of F3 is "0", the Boolean operation result is a run and when the result is "1", the Boolean operation result is an impulse. The top row of the truth table represents the polarities of both A' and B', and the left-hand column represents the particular Boolean operation to be performed.

Whenever BLU 20 performs an operation on two impulses, the operations in F1, F2, F3 and F4 are performed simultaneously. This occurs because the hardware can most efficiently calculate results concurrently. Thus, depending on whether the bit strings are equal or unequal, a determination is made as to whether the outputs of F2 or F3 will constitute the characteristic determination of the intermediate bit string. For this reason, function F5 evaluates whether the impulses are equal or unequal in length and, in accordance with this determination, chooses which outputs, F2 or F3, depict the characteristics of the intermediate bit string. An output of "0" means that the intermediate bit string is a run, and an output of "1" means that the output is an impulse. (See FIG. 9(F)). However, regardless of the function chosen by F5, the F4 function always determines the polarity of the intermediate bit string.

Functions F1 through F5 process the Boolean operations on bit strings A and B, to determine intermediate bit strings, as long as impulses remain in both bit strings. When one or both of the bit strings have all of their impulses processed, an end-of-bit-string condition occurs. When this situation occurs, the Boolean operation need not be performed. Instead, function F6 outputs a particular signal to the canonical processor 25 (FIG. 1A) to output to the resultant bit string any remaining bits in the longer bit string or to exit the routine when both bit strings have an end-of-bit-string condition (e.g., no more impulses).

Referring to FIG. 9E, a truth table of the particular results for the various Boolean operations is shown. Particularly, in the left-hand column, the operations AND, OR and EXCLUSIVE OR are shown and in the top row, the conditions of the bit strings are shown, i.e., end-of-bit-string condition in bit string A, "EBSA", end-of-bit-string condition in bit string B, "EBSB", and end-of-bit-string condition in bit strings A and B, "EBSA + EBSB".

Referring to the results portion of the map, there are three kinds of signals which are output from F6. First an "EBSA + EBSB" signal, which informs canonical processor 25 (FIG 1A) (via the GENERATE RESULTANT BIT routine (FIG. 11A)) that no more impulses reside in either bit strings A or B. Second, an "EBSA" signal, informs canonical processor 25 (via the GENERATE RESULTANT BIT STRING routine (FIG. 11A) that there are no more impulses in bit string A and that there are one or more impulses remaining in bit string B. Lastly, an "EBSB" signal, informs the canonical processor 25 (via the GENERATE RESULTANT BIT STRING routine (FIG. 11C) that there are no more impulses in bit string B and that there are one or more impulses remaining in bit string A.

When an "EBSA" condition arises in bit string A and the Boolean operation is AND, the remaining bits of bit string B are ANDed against an implied run of "0's" which follows the end of the bit string in A. In the preferred embodiment, all bit strings are assumed to have an infinite run of "0's" following the ending bit in the bit string. Thus, if the remaining bits of the longer bit string are ANDed against the infinite run of "0's", the result will always be "0s" (e.g., "1" AND "0" = "0" ; "0" AND "0" = "0"). A result of "0" means that there is no information in the resulting intermediate bit string, and thus, this step need not be performed. As a result, function F6 always outputs an "EBSA + EBSB" signal when the operation is AND. In effect, this signal means that the longer bit string is truncated to be equal in length to the shorter bit string, and the remaining bits which were truncated are not processed. Therefore, regardless of whether the bit strings are equal or unequal in length, when an end-of-bit-string condition is encountered in bit string A or bit string B, the AND operation on the bit string is considered to be completed.

When the Boolean operation is OR and EXCLUSIVE OR and an end-of-bit-string condition occurs in bit string A or B (e.g., they are unequal in length), the remaining bits in the longer bit string are output directly to the resultant bit string by the canonical processor 25 at block 232. More particularly, function F6 outputs an "EBSA" or "EBSB" signal and any remaining bits in the longer bit string are output to the resultant bit string. The remaining bits of the longer bit string are output to the resultant bit string without processing them against an infinite run of "0's" following the ending bit of the shorter bit string because the result of the EXCLUSIVE OR or OR operation on the remaining bits of the longer bit string with the infinite run of "0's" always results in the remaining bits of the longer bit string (i.e., "1" OR "0" = "1"; "0" OR "0" = "0"; "1" XOR "0" = "1"; and "0" XOR "0" = "0"). Thus, the Boolean operation need not be performed and the remaining bits of the longer bit string can be directly output by the canonical processor 25. Likewise, when an end-of-bit-string condition exits in both bit strings A and B, processing exists because the Boolean operation has completed processing on both bit strings.

So far, we have discussed in detail a hardware embodiment (FIG. 7) for performing Boolean operations and processing end-of-bit-string conditions. Now a second embodiment which could be either hardware or software (FIG. 10) for doing the same is presented.

### B. Second Embodiment for Performing BOOLEAN Operations on Compressed Impulses

As in the case of the Boolean hardware embodiment (FIG. 7) of the BLU 20 (FIG. 1A), the specific purpose of the Boolean embodiment (FIG. 10) of the BLU 20 (FIG. 1A) is for determining the characteristics of the intermediate bit string; specifically, whether the intermediate bit string is a run or an impulse, and the polarity of the run or impulse. Additionally, the purpose of the embodiment is for evaluating end-of-bit-string conditions to determine how to most effectively complete each Boolean operation.

Referring to FIG. 10, a portion of the second embodiment is implemented by a first-index table. The first-index table is made up of a series of subtables 310, 312 and 314, where each of the subtables corresponds to a particular Boolean operation. More particularly, subtable 310 corresponds to the AND operation, subtable 312 corresponds to the OR operation, and subtable 314 corresponds to the EXCLUSIVE OR operation. Each of the subtables is a matrix of one or more functions for outputting appropriate signals (i.e., "00", "EBSA", "EBSB" and "EBSA + EBSB" signals) to the canonical processor 25 (FIG. 1A).

Each subtable has three indexes. Referring to subtable 310, a first and second index for depicting the polarity of impulse A' and B' are shown at 327, 328, 317 and 321. "A'01" at 327 means that impulse A' has a polarity "0". Likewise, "B'10" at 321 means that impulse B' has polarity "1". The third index "A':B"' at 320 and 322 is for identifying whether the length of the first impulse A' is less than (<), greater than (>), or equal (=) to the length of the second impulse B'. The resulting signals at 324 and 326 (i.e., "10", "00", "01", or "11") depict the characteristics (i.e., polarity and type (run or impulse)) of the intermediate bit string resulting from a Boolean operation. In shorthand, the "00" signal stands for a run having polarity "0". Likewise, output signal "01" stands for an impulse having a polarity "0". When the Boolean operation is an AND, subtable 310 is referenced and, depending upon the characteristics of the input impulse A' and input impulse B' (i.e., polarity and length), the function referenced by the three indexes outputs a signal as depicted in matrixes 324 and 326. The output signals of the functions defined by the index table (FIG. 10) at 324 and 326, correspond directly to the outputs of functions F2, F3, F4 and F5 of the Boolean hardware embodiment (FIG. 7) discussed above.

For example, assume that an input impulse A' having a polarity "0" is ANDed with an input impulse B' having a polarity "0". In addition, consider the length of input impulse A' to be less than the length of input impulse B'. Referring to subtable 310, corresponding to the AND operation, indexes for "A'01" at 321, "B'01" at 317 and "A':B'" (<) at 322 reference the output signal "00" at 324.

Subtables 312 and 314, corresponding to Boolean operations OR and EXCLUSIVE OR, respectively, are set up as subtable 310. The subtables have three indexes and outputs of predefined functions are shown at 350, 354, 370 and 374. Likewise, the outputs depict the characteristics of the intermediate bit string generated by the EXCLUSIVE OR and OR operations.

Each of the subtables is also equipped with matrixes of results corresponding to end-of-bit-string conditions. Specifically, referring to subtable 310 for the AND operation, end-of-bit-string conditions are indexed at 332, 330 for the A and B bit strings, respectively. As shown in areas 327, 329 and 331, if an end-of-bit-string is encountered in the A bit string and/or the B bit string, the appropriate signal (i.e., "EBSA", "EBSB" and "EBSA + EBSB"), is output (FIG. 9E). The end-of-bit-string conditions for the AND operation are evaluated by the canonical processor 25 in exactly the same fashion as for output signals of function F6 of the Boolean hardware embodiment (FIG. 7) discussed above.

Likewise, the end-of-bit-string conditions for OR and the EXCLUSIVE OR are processed identically to function F6 (FIG. 7). Specifically, consider what happens during an OR operation when an end-of-bit-string condition occurs in only bit string A ("EBSA"). As discussed above, the remaining bits of bit string B will be OR'd with the infinite implied run of "0's" occurring after the end bit condition of bit string A. The OR and EXCLUSIVE OR operation always result in the remaining bits of the longer bit string as stated earlier. For this reason, the OR and EXCLUSIVE OR operation need not be performed and, instead, the remaining bits of the longer bit string are directly output to the resultant bit string by the canonical processor 25. More particularly, an "EBSA" signal resulting from the subtable 312 at 352 means to the canonical processor 25, that the remaining bits in the longer bit string B are directly output to the resultant bit string. When the end-of-bit-string condition arises for both the A and B bit strings at 348 and 340, the result is an "EBSA + EBSB" signal which signifies to the canonical processor 25 that no more bits from the bit strings need be added to the resultant bit string and the routine exits as detailed in FIG. 11A.

### C. Performing BOOLEAN Operations on Compressed Runs

To this point, the Boolean hardware embodiment (FIG. 7) and the Boolean embodiment (FIG. 10) of the BLU 20 (FIG. 1A) have been described for performing Boolean operations on compressed impulses. The Boolean operations can also be performed on compressed runs.

A compressed run format includes a first and a second indicator. The first indicator is for indicating the polarity (e.g., "0" or "1") of the one or more same polarity bits of the run. The second indicator is for indicating the length in the run. Unlike the process of determining a resultant bit string by performing Boolean operations on two impulses, the process of performing Boolean operations on two compressed runs is simplified. First, the determination of type, i.e, run or impulse, need not be determined because the immediate results are always runs. Stated differently, complex tables (i.e., FIG. 10) need not be referred to nor complex operations performed by hardware (FIG. 7) because only the polarity bits of the respective runs need be processed by the specified Boolean operation and the length of the resulting run is the shorter run.

Specifically, when a request for processing a Boolean operation on two particular bit strings is made, and the bit strings have been separated into series of runs, the bit strings are retrieved from secondary memory 16 and brought by bus 17 to buffer memory 18. When the bit strings are loaded into the BLU via bus 19, the BLU 20 performs the particular Boolean operation specified on the polarities of the runs and intermediate results are tabulated. The first step in performing Boolean operations on bit strings containing compressed runs is to obtain the first run in the first and second bit strings. The BLU 20 then determines whether the first and second bit string runs are equal or unequal in length by comparing the length indicators of the compressed run formats. If the runs of the first and second bit strings are unequal in length, then the BLU 20 determines the length of the shorter run. The shorter length is the length of the bits of the intermediate resultant bit string. In other words, only the bits of the shorter run are processed against the same number of bits of the longer run to determine an intermediate resultant run. All of the runs of both bit strings are processed in this fashion until there are no more runs left to process. The intermediate resultant bit strings are then tabulated together to form a resultant bit string. Once the length of the intermediate resultant bit string is determined, the polarity of the intermediate resultant bit string is efficiently determined by performing the specified Boolean operation only the polarity indicator of the first run with the polarity indicator of the second run. The result of this operation is the polarity of the intermediate resultant bit string.

If the comparison of the first and second bit string runs results in a determination that the runs are equal in length, then the length of the intermediate resultant bit string is set equal to the length of either the first or the second runs. The length of the intermediate resultant bit string is equal to the length of either run because both runs will be fully processed against each other to generate the intermediate resultant bit string. Once the length of the intermediate resultant run is determined, the polarity of the intermediate resultant run is determined by processing the specified Boolean operation on the polarity indicator of the first run with the polarity indicator of the second run.

As in the case of processing compressed impulses, only the bit lengths and polarity indicators of the runs are processed. This configuration creates a process efficiency because not all of the bits of the run need to be processed one at a time. The intermediate resultant bit strings also reside in compressed run formats and they are combined to generate the resultant compressed bit string.

### D. Canonical Processing of Intermediate Bit Strings

Referring to FIGS. 11A, 11B, 11C, 12A and 12B, a detailed description of the canonical processor (25, FIG. 1A and FIG. 11C) is now discussed. Specifically referring to FIG. 11A, a detailed flow diagram of the canonical processor 25, called GENERATING RESULTANT BIT STRING routine, for controlling the component of the canonical processor 25, is shown. The hardware components of the canonical processor 25 are shown at FIG. 11C. The overall purpose of the canonical processor 25 is for properly combining an intermediate bit string (i.e., run or impulse) with another intermediate bit string (i.e., run or impulse) to form an impulse of the resultant bit string. Additionally, the canonical processor processes end-of-bit-string conditions as discussed earlier. Essentially, via the GENERATING RESULTANT BIT STRING routine the canonical processor 25 interprets a state variable (FIG. 11B), which references a second index table (FIG. 12A) to determine how to process the outputs of the Boolean hardware embodiment (FIG. 7) or the Boolean embodiment (FIG. 10). The state variables are combinations of set bit-flags which are depicted in FIG. 12B.

FIG. 11C represents the hardware components of the canonical processor 25 (FIG. 1A) for buffering intermediate bit strings and generating a resultant bit string. The hardware components for connecting the intermediate bit strings together are input buffer 383, element buffer 385, and static buffer 387. The intermediate bit string results are output from the Boolean hardware or software embodiments at block 230 of FIG. 6. The intermediate bit string is then sent to the input buffer 383 of FIG. 11C for temporary holding. The canonical processor 25 then determines how to combine or not to combine the contents of the input buffer 383 with the contents of the element buffer 385 to form an impulse of the resultant bit string. The impulse of the resultant bit string is output to the static buffer 387. The purpose of static buffer 387 is to hold all of the generated encoded impulses in proper order until bit string is complete. After both bit strings are fully processed, (e.g., end-of-bit-string conditions occur) the contents of the static buffer 358 is the final compressed resultant bit string and it is output to buffer memory 389. The resultant bit string resides in buffer memory 389 temporarily until it can be placed into secondary memory 401 (16, FIG. 1A) or provided to the BLU 20 for additional Boolean processing.

### 1) Generate Resultant Bit String Routine

The GENERATE RESULTANT BIT STRING routine (FIG. 11A) coordinates the components of the canonical processor FIG. 11C, as discussed above. In particular, in block 384 the intermediate bit string generated from BLU 20 hardware (FIG. 7) or BLU 20 second embodiment (FIG. 10) is placed into the input buffer 386 (FIG. 11C). In block 386 a state variable (418, FIG. 11B), for processing the contents of the input buffer 383 and element buffer 385 is determined by reviewing the second index table (FIG. 12A). The state variable is made up of five bits, each bit representing a different flag; TAKE 1 at 420, TAKE N at 422, PUT-STAT BUFF at 424, SET-ELEM BUFF at 426, OUT-STAT BUFF at 428. The first flag, TAKE 1, indicates that there is a run in the element buffer 385 having a particular polarity and it needs to be combined with a run or an impulse in the input buffer 383 having an opposite polarity; (e.g. a run having a polarity of "0" combined with a run or impulse having a polarity of "1"). The second flag, TAKE N, indicates that there is a run having a particular polarity which resides in the element buffer 385, and it needs to be combined with a run or impulse of the same polarity currently in the input buffer 383 (e.g., a run having polarity "0" combined with a run or impulse having polarity "0"). The third flag PUT-STAT BUFF indicates that a newly formed impulse exists in the element buffer 385 and it needs to be placed into the static buffer 387. The fourth flag SET-ELEM BUFF indicates that the contents of the input buffer 383 need to be placed into the element buffer 385. The fifth flag, OUT-STAT BUFF, indicates that the static buffer 387 contains a completed resultant bit string which needs to be output to buffer memory 389 for temporary storage.

Returning to block 386 of FIG. 11A, once the state variable 314 (FIG. 11B) is retrieved from the second index table (FIG. 12A) (a detailed discussion on the retrieval process will follow shortly), the remaining blocks 388, 396, 402, 406 and 410 (FIG. 11A) are entered to have the canonical processor determine which flags are set in the state variable 418 (FIG. 11B). Specifically, in decision block 388 the canonical processor determines whether the TAKE 1 flag 420 of the state variable 418 is set. If flag 420 is set, then in block 390, a bit from the contents of the input buffer 383 (FIG. 11C) is appended to the contents of the element buffer 385 (FIG. 11C). In block 392 the length indicator for the impulse, now residing in the element buffer 385, is incremented. Additionally, in block 394 the length indicator, for the contents of the input buffer 383, is reduced by one.

If the TAKE 1 flag 420 of the state variable 418 is not set, or if processing in blocks 390, 392 and 394 is completed, then in decision block 396 the canonical processor will determine whether the TAKE N flag 422 of the state variable 418 is set; Assuming that the TAKE N flag 422 is set, block 398 is entered to take N bits from the contents of the input buffer 383 and to append the N bits to the contents of the element buffer 385. Block 400 is entered to add N to the length of the impulse now residing in the element buffer 385. If the TAKE N flag 422 of the state variable 418 (FIG. 11B) is not set, or if processing in blocks 398 and 400 is completed, processing will continue in decision block 402 to determine whether the PUT-STAT BUFF flag 424 is set. Assuming that the PUT-STAT BUFF flag 424 is set, block 404 is entered to output the contents of the element buffer 385 to the static buffer 387. If the PUT-STAT BUFF flag 424 is not set, or if processing in block 404 is completed, then processing will continue in block 406 to determine if the SET-ELEM BUFF flag bit 426 is set. If the flag bit 426 is set, then in block 408 the contents of the element buffer 385 (FIG. 11C) is replaced with the contents of the input buffer 383 (FIG. 11C). If the flag bit 426 is not set, or if processing in block 408 is completed, then processing will continue in block 410 to determine if the OUT-STAT BUFF flag bit 428 is set. If this bit is set, then block 412 is entered to output the contents of the static buffer 387 to buffer memory 389 and block 414 is entered to exit the GENERATE RESULTANT BIT STRING routine. If the OUT-STAT BUFF flag bit 428 of state variable 418 is not set, then processing returns to the PROCESS BOOLEAN OPERATION routine (FIG. 6) in block 234.

### 2) Second Index Table

Referring to FIG. 12A, a detailed description of the second index table which is a portion of the canonical processor 25 (FIG. 11C) will now be discussed. The second index table is essentially an indexing configuration for determining which set of flags of the state variable (FIG. 11B) are set. As stated earlier, the state variable directs the canonical processor how to process the intermediate bit strings residing in the input and element buffer (383 and 385 of FIG. 11C). The left-hand column 432 of the second index table represents the contents of the element buffer 385 (FIG. 11C). For example, the contents of the element buffer 385 could be an impulse having polarity of "0" 444, an impulse having polarity of "1" 446, a run having polarity "0" 448, a run having polarity of "1" 450 or be empty "MTY" 452. The top portion of the second index table (FIG. 12A) depicts the contents of the input buffer 383 (FIG. 11C). The contents of the input buffer 383 (FIG. 11C) can be an impulse having polarity of "0" 434, an impulse having polarity of "1" 436, a run having polarity "0" 438, a run having polarity "1" 440 or an end-of-bit-string condition in both bit string A and bit string B, "EBSA + EBSB" 442. By knowing the contents of the element buffer 385 and the contents of the input buffer 383, a particular state variable (FIG. 11B) for directing the canonical processor 25 (FIG. 11C) will be referenced. For example, if the contents of the element buffer is a run having polarity "0" 448 and the contents of the input buffer is a run having polarity "0", then the state variable "01000" at 478 is referenced. The second bit of the state variable is set, corresponding to the TAKE N flag.

For convenience, each result to be referenced in the second index table (FIG. 12A) has been given a name which is broken up into two parts; for example, "00-01". The first part, before the dash, corresponds to the contents of the element buffer 385 (FIG. 11C), and the second part corresponds to the contents of the input buffer 383 (FIG. 11C). For example, "00-01" means that the contents of the element buffer 385 (FIG. 11C) is a run with a polarity of "0" 448 and the contents of the input buffer is an impulse with a polarity of "1" 436. "01-XX" means that the contents of the element buffer 385 (FIG. 11C) is an impulse having polarity "1" and the contents of the input buffer 383 (FIG. 11C) is a run or an impulse of either polarity ("0" or "1"). "11-EBSA + EBSB" at 500 indicates that the contents of the element buffer 385 (FIG. 11C) is a run having polarity "1" 450, and the contents of the input buffer 383 (FIG. 11C) is a signal indicating an end-of-bit-string condition in both bit strings A and B 442.

FIG. 12B depicts each result of the second index table. Specifically, each row of FIG. 12B corresponds to a different result. The second index table can be broken up into six parts; column 532 for result names, column 534 for the state variables associated with each result, column 536a for the TAKE N and TAKE 1 flags, column 538 for the resultant bit string, column 540 for the PUT-STAT BUFF flag and column 542 for both the SET-ELEM BUFF flag and the OUT-STAT BUFF flag.

Referring to FIGS. 12A and 12B, a detailed description of each result that may be referenced by the second index table is presented. When an impulse of any length having a polarity "0" is in the element buffer (444, FIG. 12A) and the contents of the input buffer is an impulse having polarity "0" (434, FIG. 12A), or an impulse having polarity "1" (436, FIG. 12A), or a run having polarity "0" (438, FIG. 12A), or a run having polarity "1" (440, FIG. 12A), the "01-XX" result at 454, 464, 474 and 484 is referenced. The "01-XX" result has a state variable (FIG. 11B) of "00110" which means that in all cases enumerated both the PUT-STAT BUFF flag and SET-ELEM BUFF flag are set (504, FIG. 12B). In accordance with the flags set in the state variable, the GENERATE RESULTANT BIT STRING routine (FIG. 11A) instructs the canonical processor 25 to take the impulse having polarity "0" in the element buffer 385 and places it into the static buffer 387. Also, the contents of the input buffer 383 are placed into the element buffer 385. The impulse having polarity "0" in the static buffer (row 504, column 538, FIG. 12B) becomes an impulse of the resultant bit string.

Referring back to FIG. 12A, when the contents of the element buffer 385 (FIG. 11C) is an impulse having polarity "1" (446, FIG. 12A) and the contents of the input buffer is an impulse having polarity "0" 434, an impulse having polarity "1" 436, a run having polarity "0" 438, or a run having polarity "1" 440, the result is "10-XX" 456, 466, 476 and 486 (506, FIG. 12B). Result "10-XX" has a state variable "00110" which is identical to the state variable for "01-XX" (504, FIG. 12B), and thus the same flags PUT-STAT BUFF and STAT-ELEM BUFF are set. The only difference in the two results occurs in the resultant bit string; static buffer 387 (FIG. 11C) has an impulse having a polarity "1" added to it (506, 538, FIG. 12B) instead of an impulse having polarity "0".

When the contents of the element buffer is an impulse having polarity "0" 444 (FIG. 12A) and the contents of the input buffer is an "EBSA + EBSB" 442 (FIG. 12A) signal, the "01-EBSA + EBSB" result is referenced at 494 (FIG. 12A). This result has state variable "00101" (508, 534, FIG. 12B) and the flags PUT-STAT BUFF and OUT-STAT BUFF are called. The purpose of this result is to instruct the canonical processor to first take the contents of the element buffer 385 (FIG. 11C) and place it into the static buffer 387 (FIG. 11C), and second, to take the contents of the static buffer 387 (FIG. 11C) -- the resultant bit string -- and output it to the buffer memory 389 (FIG. 11C). The end-of-bit-string condition signifies that the impulse residing in the element buffer 385 is the last impulse processed and it can be directly output to the static buffer 387 (FIG. 11C). Once the last impulse is placed into the static buffer, the resultant bit string is complete, and it can be output from the static buffer 387 (FIG. 11C) to = buffer memory 389 (FIG. 11C).

If the contents of the element buffer 385 (FIG. 11C) is an impulse having polarity "1" 446 and the contents of the input buffer 383 (FIG. 11C) is an "EBSA + EBSB" signal (442, FIG. 12A), then the "10-EBSA + EBSB" result (496, FIG. 12A) is referenced. This result has the same state variable "00101" as result "01-EBSA + EBSB" discussed above. However, an impulse with a polarity "1" instead of polarity "0" is output to the static buffer 387 (510, 538, FIG. 12(B)).

If the contents of the element buffer 385 (FIG. 11C) is a run having polarity "0" 448 and the contents of the input buffer 383 (FIG. 11C) is a run having polarity "0" 438, then the result "00-00" 478 (512, FIG. 12B) is referenced. The "00-00" result has a state variable "01000" which signifies that the flag TAKE-N is set. When the TAKE-N bit is set, the GENERATE RESULTANT BIT STRING routine (FIG. 11A) instructs the canonical processor 25 (FIG. 11C) to take all of the bits in the input buffer 383 (FIG. 11C) and append them to the contents of the element buffer 385. The result is a run having a polarity "0" (512, 538, FIG. 12B). The run having polarity "0" resides in the element buffer 385 (FIG. 11C) until one or more bits can be later added to it to form an impulse.

If the contents of the element buffer 385 (FIG. 11C) is a run having polarity "0" 448 and the contents of the input buffer 383 (FIG. 11C) is an impulse having polarity "0" 434, then the result is "00-01" 458 (514, FIG. 12B). The state variable for result "00-01" is "01000" (514, 534, FIG. 12(B)). This state variable is the same as state variable for result "00-00", except an impulse in the input buffer 383 (FIG. 11C) is combined with a run in the element buffer 385 (FIG. 11C) to form another impulse having polarity "0" (514, 538, FIG. 12B).

When the contents of the element buffer 385 (FIG. 11C) is a run having polarity "0" 448 and the contents of the input buffer 383 (FIG. 11C) is an impulse having polarity "1" 436, or a run having polarity "1" 440, the "00-1X" result 468, 488 (516, FIG. 12B) is referenced. Result "00-1X" has state variable "10110" (516, 534, FIG. 12B), which means the TAKE-1 bit, PUT-STAT BUFF bit and the SET-ELEM BUFF flags are set. The GENERATE RESULTANT BIT STRING routine (FIG. 11A) instructs the canonical processor 25 (FIG. 11C) to take a bit from the input buffer 383 (FIG. 11C) and append it to the contents of the element buffer 385 (FIG. 11C) to form an impulse out of the run having a polarity "0" (516, 538, FIG. 12B). The contents of the element buffer 385 (FIG. 11C) will be output to the static buffer 387 (FIG. 11C). Lastly, the contents of the input buffer 383 (FIG. 11C), having one less bit, will be placed into the element buffer 385 (FIG. 11C).

When the contents of the element buffer 385 (FIG. 11C) is a run having polarity "1" 450 and the contents of the input buffer 383 (FIG. 11C) is a impulse 434 or a run 438 having a polarity "0", the "11-OX" result at 460 and 480 (518, FIG. 12B) is referenced. The result "11-OX" has state variable "10110" (516, 534, FIG. 12B), which is the same as the state variable for result "001X". Thus, the same processing occurs; however, the static buffer 387 (FIG. 11C) contains an impulse having a polarity "1" instead of polarity "0" (518, 538, FIG. 12B).

If the contents of the element buffer 385 (FIG. 11C) is a run having a polarity "1" 450 and the contents of the input buffer 383 (FIG. 11C) is an impulse having polarity "1" 436, result "11-10" 470 (520, FIG. 12B) is referenced. Result "11-10" has a state variable "01000" (520, 534, FIG. 12B) which means that the TAKE-N flag is set. The GENERATE RESULTANT BIT STRING routine (FIG. 11A) instructs the canonical processor 25 (FIG. 11C) to take all "N" bits from the input buffer 383 (FIG. 11C) and append these bits to the end of the contents of the element buffer 385 (FIG. 11C). Effectively, an impulse having a polarity "1" (520, 538, FIG. 12B) is created.

If the contents of the element buffer 385 (FIG. 11C) is a run having polarity "1" 450 and the contents of the input buffer 383 (FIG. 11C) is a run having polarity "1" 440, result "11-11" 490 (524, FIG. 12B) is referenced by the second index table (FIG. 12A). The result "11-11" has a state variable "01000", which is the same state variable as for the result "11-10" (520, FIG. 12B). In other words, the same operation occurs; however, because there is a run having polarity "1" in the input buffer 383 (FIG. 11C) instead of an impulse having polarity "1", the result is a run having a polarity "1" (524, 538, FIG. 12B) instead of an impulse having polarity "1" (520, 538, FIG. 12B).

If the contents of the element buffer 385 (FIG. llC) is a run having polarity "1" 450 and the contents of the input buffer is an "EBSA + EBSB" signal 442, then result "11-EBSA + EBSB" 500 (526, FIG. 12B) is referenced in the second index table (FIG. 12A). Result "11-EBSA + EBSB" has a state variable "10101" (526, 534, FIG. 12B) which means that the TAKE-1 flag is set, the PUT-STAT BUFF flag is set and the OUT-STAT BUFF flag is set. The GENERATE RESULTANT BIT STRING routine (FIG. 11A) instructs the canonical processor 25 to take a bit from the contents of the input buffer 383 (FIG. 11C) and append it to the contents of the element buffer 385 (FIG. 11C) to form an impulse having a polarity "1" (row 526, column 538, FIG. 12B). The impulse having polarity "1 "is then placed into the static buffer 387, and the final resultant bit string in the static buffer 387 (FIG. 11C) is output to buffer memory 389.

When the contents of the element buffer 385 (FIG. 11C) is a run having polarity "0" 448, or when the element buffer 385 (FIG. 11C) is empty 452, and the contents of the input buffer 383 (FIG. 11C) is an "EBSA + EBSB" signal 442, result "PUT-EBSA + EBSB" at 498 and 502 (528, FIG. 12B) is referenced by the second index table (FIG. 12A). Result "PUT-EBSA + EBSB" has a state variable "00001" (528, 534, FIG. 12B) which means that the OUT-STAT BUFF flag is set. The canonical processor 25 will detect the set flag and output the contents of the static buffer 387 to buffer memory 389 (FIG. 11C). In other words, the canonical processor 25 (FIG. 11C) sees the element buffer 385 (FIG. 11C) as if it is an empty element buffer 385 (FIG. 11C), regardless of whether it contains a run of "0's". If the element buffer 385 (FIG. 11C) has a run of "0's", or if it is empty, and the contents of the input buffer 383 (FIG. 11C) is an "EBSA + EBSB" signal the static buffer 387 (FIG. 11C) contents can be output directly to buffer memory 389 (FIG. 11C).

If the contents of the element buffer 385 (FIG. 11C) is empty 452 and the contents of the input buffer 383 (FIG. 11C)is an impulse or a run at 434, 436, 438 and 440 respectively, the result SET-ELEM BUFF at 462, 472, 482 and 492 (530, FIG. 12B) is referenced by the second index table (FIG. 12A). The subroutine SET-ELEM BUFF has a state variable "00010" which means that the SET-ELEM BUFF flag is set. The canonical processor 25 (FIG. 11C) will detect the set flag and move the contents of the input buffer 383 (FIG. 11C) into the element buffer 385 (FIG. 11C). In other words, the contents of the element buffer 385 (FIG. 11C) is empty, so the contents of the input buffer 383 (FIG. 11C) can be directly input into the element buffer. This result typically occurs at the very beginning of a Boolean operation when the contents of the element buffer 385 (FIG. 11C) is still empty.

### 3) A Detailed Example of the Boolean AND Operation With Two Compressed Bit Strings

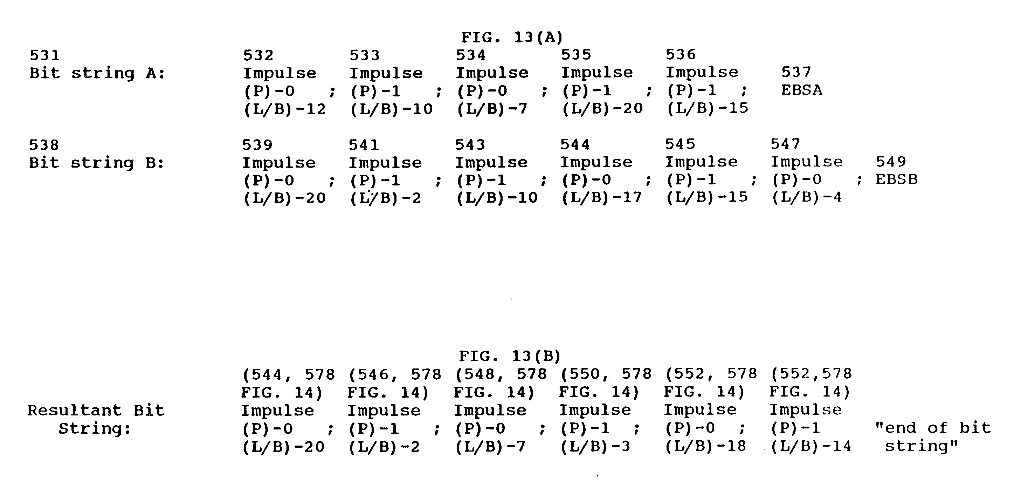

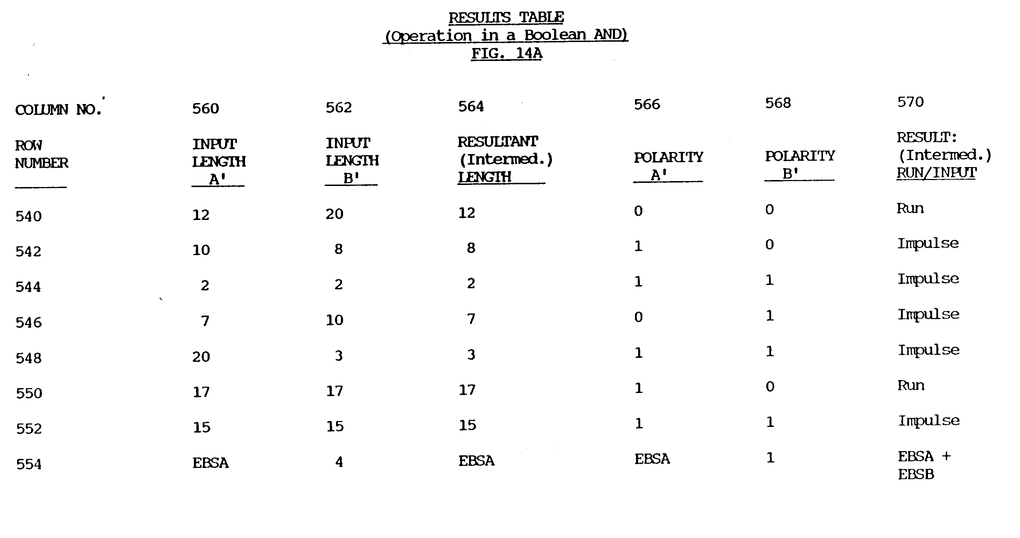

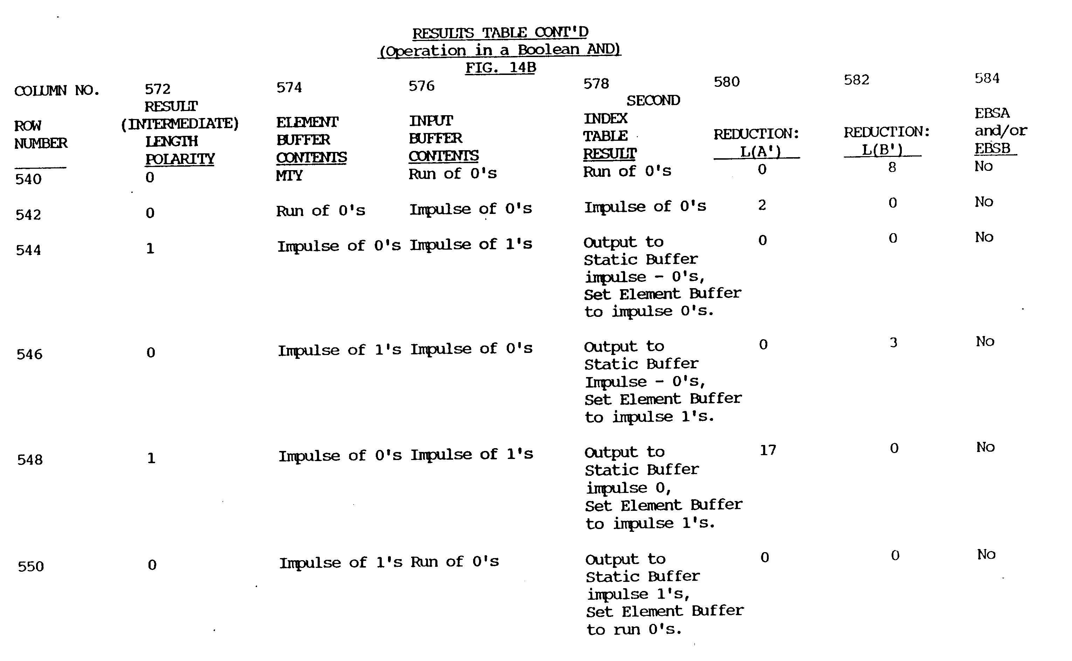

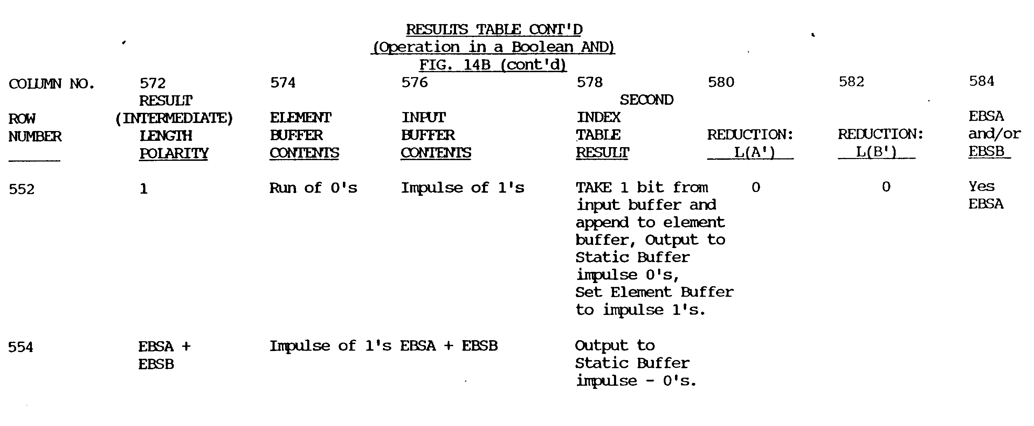

Referring to FIGS. 13A, 13B, 14A and 14B, a detailed example is presented for processing a Boolean AND operation on two compressed bit strings. More particularly, assume that two bit strings, A and B, have been downloaded from external device 12 via bus 13

FIGS. 14A and 14B are detailed results tables of results of the various steps performed by system coordinator 31 (FIG. 1A) via the PROCESS BOOLEAN OPERATION Routine (FIG. 6) on the bit strings 531 and 538. Each row of FIGS. 14A and 14B, indicated at 540 through 554, is equivalent to processing an element (impulse or run) of bit string A with an element (impulse or run) of bit string B. Each row of FIGS. 14A and 14B is separated into 13 subparts which correspond to the 13 different columns of the results table, indicated at 560 through 584. Specifically, the length of impulse A' 560, the length of impulse B' 562, the length of the intermediate resultant bit string 564, the polarity of impulse A' 566, the polarity of impulse B' 568, whether the intermediate bit string is a run or impulse 570, the polarity of the intermediate bit string 572, the contents of the element buffer 574, the contents of the input buffer 576, the result of the second index table 578, reduction of impulse A' 580, reduction of impulse B' 582, and whether an EBSA or EBSB condition exists; are all depicted as column headers in the results tables (FIGS. 14A and 14B).

Once the compressed bit strings A (531 in FIG 13A) and B (538 in FIG. 13A) are loaded into the BLU 20 (FIG. 1A), the system coordinator 31 (FIG. 1A) commences processing in the PROCESS BOOLEAN OPERATION routine (FIG. 6). In block 222 the first impulse A' 532 is obtained from bit string A (531, FIG. 13A) and in block 224 the first impulse B' 539 is obtained form bit string B (538, FIG. 13A). The length of impulse A' is 12 bits (row 540, column 560, FIG. 14A) and the length of impulse B' is 20 bits (540, 562, FIG. 14A). In block 226 the minimum bit length of impulse A' and B' is determined to be 12 bits (540, 564, FIG. 14). The 12 bit length is the length of the intermediate resultant to computer platform 10. Here, the bit strings are encoded into the compressed impulse formats of FIGS. 2A, 2B, 2C, and 2D by encoder 14 as discussed earlier (FIGS. 3A, 3B, and 3C). The resulting compressed bit strings are stored in secondary memory 16 and stay there until a request for performing the AND operation is made. When requested, the two compressed bit strings A and B are loaded into buffer memory 18 where they wait to be processed by the BLU 20. Examples of the compressed bit strings A and B are shown in FIG. 13A at 531 and 538. For ease of understanding, the impulses have been separately described rather than depicted in their actual encoded formats. However, the impulses are assumed to be in their compressed formats (FIGS. 2A, 2B, 2C, and 2D). For example, impulse 532 has a polarity (P) of "0" and a length (L/B) of 12 and would normally be represented in a one-pack (FIG. 2A). Compressed bit string A comprises impulses 532, 533, 534, 535, 536 and 537. Compressed bit string B comprises impulses 539, 541, 543, 544, 545, 547 and 549.

When the BLU 20 is ready for processing, the system coordinator (31, FIG. 1A) brings the compressed bit strings A and B via bus 19 to the BLU 20. Here the AND Boolean operation is performed on compressed bit strings A and B and intermediate resultant bit strings are generated and sent to the canonical processor 25 via bus 21. When the Boolean operation has finished processing the impulses in either bit string, canonical processor 25 outputs a resultant bit string to buffer memory 18 via bus 23. Here the compressed resultant bit string resides until it is sent via bus 27 to secondary memory 16 or until it is sent via bus 19 to BLU 20 for further processing. FIG. 13B shows the resultant compressed string comprising six impulses and "end of bit string." bit string. In block 228, the length of impulse A' is determined to be less than impulse B' and in block 230 the Boolean hardware (FIG. 7) or the Boolean second embodiment (FIG. 10) embodiments are initiated to determine the type (run or impulse) and polarity of the intermediate bit string.

Referring to the hardware embodiment (FIG. 7) of the BLU 20 (FIG. 7) functions F1 256 and F2 258, are performed because impulses A' and B' are unequal in length (e.g., A' is 12 bits and B' is 20 bits). In actuality, function F3 262, is processed simultaneously, however, function F5 263, only chooses outputs from function F2 258 when the bit length of A' 532 (FIG.13A) and B' 539 (FIG. 13A) are unequal. Function F1 determines that impulse B' 539 (FIG. 13A) is the longer impulse and thus, the polarity of impulse B' ("0") is chosen by function F1 (FIG. 9A). When the impulses A' 532 (FIG. 13A) and B' 539 (FIG. 13A) have a polarity "0" and the length of impulse A' 532 (FIG. 13A) is less than the length of impulse B' 539 (FIG. 13A), the output of F1 is "0" or the polarity of the longer impulse B' 539 (FIG. 13A). Function F2 then determines the type (run or impulse) of the intermediate bit string. Referring to FIG. 9B, when the Boolean operation is an AND and the result of F1 is "0", the output of F2 is "0", which means that the intermediate resultant bit string is a run. When F1 and F2 are processing, F4 simultaneously determines the polarity of the intermediate bit string by performing the Boolean operation AND on the polarities of impulse A' 532 (FIG. 13A) and impulse B' 539 (FIG. 13A). Referring to FIG. 9C, the ANDing of a polarity of "0" and a polarity of "0" results in a polarity of "0". Thus, the intermediate bit string, as output by function F5, is a run (540, 570, FIG. 14A) having a polarity of "0" (540, 572, FIG. 14B).

The same intermediate bit string determination occurs when the Boolean embodiment (FIG. 10) performs the AND operation. Specifically, the first subtable 310 for the AND operation is referenced. Impulse A' 532 (FIG. 13A) is an impulse having polarity "0" or "A'01" at 327, and impulse B' 539 (FIG. 13A) is an impulse having polarity "0" or "B'01" at 317. The length of A'01 is less than B'01, corresponding to the less than symbol (<) at 322. The output referenced by the subtable 310 shows the results of "00" signal, meaning that the intermediate bit string is a run having a polarity "0", which is the same result determined by the Boolean hardware embodiment (FIG. 7) discussed above.

When processing is completed by the BLU 20, the canonical processor 25 (FIG. 11C) is called by the system coordinator in block 232 of FIG. 6. Specifically in block 384 of the GENERATE RESULTANT BIT STRING routine (FIG. 11A) the intermediate bit string calculated by the BLU 20 (FIG. 1A) is placed into the input buffer 383 (FIG. 11C) of the canonical processor 25 (FIGS. 1A and 11C). The input buffer 383 (FIG. 11C) inputs a run of "0's" (540, 576, FIG. 14B), and the element buffer 385 (FIG. 11C) is empty (540, 574, FIG. 14B). Block 386 (FIG. 11A) is entered to have the canonical processor 25 (FIG. 11C) obtain the navigation vector, as referenced by the second index table (FIG. 12A), which is associated with a run of "0's" in the input buffer (438, FIG. 12A) and an empty element buffer (452, FIG. 12A). The referenced result is SET-ELEM BUFF (482, FIG. 12A) having state variable "00010" (530, 534, FIG. 12B). In decision block 388 (FIG. 11A), the flag bit, TAKE 1, in the state variable, is determined not to be set and in decision block 396 (FIG. 11A) the TAKE N bit is determined also not to be set. Processing continues at decision block 402 (FIG. 11A) which also determines that the PUT-STAT BUFF flag is not set. In block 406 (FIG. 11A) the SET-ELEM BUFF bit is determined to be set. Thus, block 408 (FIG. 11A) is entered to replace the element buffer 385 (FIG. 11C) contents with the contents of the input buffer 383 (FIG. 11C). In decision block 410 (FIG. 11A) the OUT-STET BUFF flag is determined not to be set, so processing returns in block 416 (FIG. 11A) to decision block 234 of the PROCESS BOOLEAN OPERATION routine (FIG. 6).

In block 234 (FIG. 11A) an end-of-bit-string condition is determined not to exist for either bit string A or bit string B, and processing continues in block 235, which reduces the length of impulse A' and the length of impulse B' by the minimum length in bits calculated at block 226 (FIG. 6). In decision block 240 the length for impulse A' has been reduced to zero bits and, in block 242 the next impulse, impulse 533 of FIG. 13A is obtained from bit string A. In block 224 the length for impulse B' 539 (FIG. 13A) is determined not to be reduced to zero bits; it was reduced to 8 bits (540, 582, FIG. 14B) specifically. Impulse B'539 (FIG. 13A) was 20 bits long and it was reduced by 12 bits, leaving only eight bits. Decision block 248 is entered and an end-of-bit-string condition does not exist in either bit string A or bit string B after the reduction of the minimum length from both A' and B' (540, 584, FIG. 14B).

The above-described operation is repeated for each of the remaining impulses of strings A and B, as summarized in FIGS. 14A and 14B, rows 542 through 554. When the length of the last impulse A' is reduced to zero (552, 580, FIG. 14B), during block 242 the next impulse 537 (FIG. 13A) from the bit string A 531 (FIG. 13A) is obtained. During decision block 244, the length for impulse B' is determined to be reduced to zero (552, 582, FIG. 14B), and block 246 obtains the next impulse 547 (FIG. 13A) from bit string B 538 (FIG. 13A).

In decision block 248 of FIG. 6, an end-of-bit-string condition is determined to exist in bit string A. The last group of bits 537 (FIG. 13A) acquired from bit string A 531 (FIG. 13A) is an extended element format for depicting an end-of-bit-string condition in bit string A (FIG. 2D). Thus, block 231 returns processing to block 230 to perform the hardware or software BLU embodiments to determine the type and polarity of the intermediate bit string.

Referring to FIG. 7, the BLU hardware embodiment performs the F6 function 265 for determining how to process an end-of-bit-string condition. Specifically, referring to FIG. 9E, when an end-of-bit-string condition exists in bit string A and the Boolean operation is AND, the hardware configuration outputs a "EBSA + EBSB" signal to signify that an end-of-bit-string condition exists in both bit string A and bit string B independent of the information remaining in B. The BLU embodiment (FIG. 10) also outputs an "EBSA + EBSB" signal to signify an end-of-bit-string condition in both bit string A and bit string B. Specifically, the end-of-bit-string condition for bit string A is indexed at 332 of the first index table (FIG. 10). Bit string B contains an impulse having polarity "0" or "B'01" at 317 (FIG. 10). The result determined is an "EBSA + EBSB" signal at 327. Returning to FIG. 6, the "EBSA + EBSB" signal is output from block 230 to the canonical processor 25 (FIG. 11C) via the GENERATE RESULTANT BIT STRING routine (FIG. 11A) at block 232. In block 384 of FIG. llA, the "EBSA + EBSB" signal is placed into the input buffer 383 (FIG. 11C). In block 386, the canonical processor 25 (FIG. 11C) references the second index table (FIG. 12A) to determine the state variable which instructs the remaining portion of the canonical processor 25 (FIG. 11C) how to process the end-of-bit-string condition. The element buffer 385 (FIG. 11C) contains an impulse having polarity "1" at 446 (FIG. 12A). The input buffer 383 (FIG. 11C) is an "EBSA + EBSB" signal at 442. Thus, the result referenced by the second index table is "10-EBSA + EBSB" at 496 (FIG. 12A). "10-EBSA + EBSB" has state variable "00101". In decision blocks 388, 396, 402, 406, 410 of FIG. 11A the canonical processor evaluates the state variable obtained from the second index table (FIG. 12A) and determines that the PUT-STAT BUFF flag and the OUT-STAT BUFF flag are set 510 (FIG. 12B). More particularly, in decision block 388 the TAKE 1 flag is determined not to be set and in block 396 the TAKE N flag is also determined not to be set. In block 402 the PUT-STAT BUFF flag is determined to be set and in block 404, the contents of the element buffer (385, FIG. 11C) (e.g., an impulse having polarity "1") outputs to the static buffer (387, FIG. 11C). In decision block 406, the SET-ELEM BUFF flag is determined not to be set and in block 410, the OUT-STAT BUFF flag is determined to be set. In block 412, the contents of the static buffer 385 (FIG. 11C), a resultant compressed bit string, are output to buffer memory 389 (FIG. 11C) and in block 414 the canonical processor 25 (FIG. 11C) stops processing and exits program PROCESS BOOLEAN OPERATION (FIG. 6). The compressed resultant bit string generated by the GENERATE RESULTANT BIT STRING routine (FIG. 11C) is shown in FIG. 13(B). Each impulse output from the element buffer 385 (FIG. 11C) to the static buffer 387 (FIG. 11C) is separately depicted in FIG. 13B.

## Claims

1. A method using a computer for converting (FIG. 3) a string of repetitive data comprising a string of binary bits of indefinite length (FIG. 4A) into a compressed impulse format (FIG. 4B) upon which boolean operations can be performed and which is represented by a first value indicating the repetitive data and a second value indicating the number of repetitions, characterized in that:
the successive bits of the string are grouped into a corresponding sequence of one or more uncompressed impulses which together constitute substantially the entire bit string (FIG. 4A; 120), each of the one or more uncompressed impulses comprising a run of one or more contiguous bits of the string having the same polarity and an ending bit at one end of the string having a polarity opposite from the said same polarity of the associated impulse (FIG. 4A; 124, 130, 136, 144); and
each of the one or more uncompressed impulses (FIG. 4A; 124, 130, 136, 144) is encoded in sequence into a corresponding sequence of compressed impulse formats (FIG. 4B; 142, 150, 154, 168), each having a fixed length (FIG. 2A), one compressed impulse format for each and every uncompressed impulse, the compressed impulse format comprising, for the first value, a first binary bit coded indicator (FIG. 2A; 24) and, for the second value, a second binary bit coded indicator (FIG. 2A; 26), the first indicator (FIG. 2A; 24) indicating the polarity of the one or more same polarity bits of the corresponding uncompressed impulse and the second indicator (FIG. 2A; 26) indicating the quantity of the same polarity bits grouped in the corresponding uncompressed impulse.

2. The method according to Claim 1, further characterized in that:
the quantity of bits in the uncompressed impulses is determined (FIG. 3A; 72) for one or more of the impulses; and
the encoding of the one or more uncompressed impulses (FIGS. 3A-3B; 83, 89, 90, 92) includes forming common format words having the compressed impulse format, and forming, in each of the common format words, a representation of the first indicator (FIG. 2A; 24) and the second indicator (FIG. 2A; 26) for each of a variable number of the one or more uncompressed impulses, where such variable number varies depending on the quantity of bits determined.

3. The method according to Claim 2, further characterized in that:
each common format word is formed into a format indicator (FIG. 2; 22, 28, 38, 52) which is an indication of the number of the one or more uncompressed impulses.

4. The method according to Claim 1, wherein the encoding of the one or more uncompressed impulses (FIG. 4B; 122) is further characterized in that:
each of the one or more uncompressed impulses is encoded into a first compressed impulse format when encoding an impulse having a length of bits of 2 to 31 bits (FIG. 3; 88, 90), a second compressed impulse format when encoding an impulse having a length of bits of 32 to 2³²-1 bits (FIG. 3; 92), a third compressed impulse format when encoding two impulses, each having a length of bits of 2 to 5 bits (FIG. 3; 84, 89, 95, 102), or a fourth compressed impulse format when encoding three impulses, each having a length of bits of 2 or 3 bits (FIG. 4; 83, 97, 108).

5. The method according to Claim 1, further characterized in that:
the second indicator is encoded to indicate the quantity of the same polarity bits grouped in the corresponding uncompressed impulse plus the ending bit having a polarity opposite from the said same polarity bits.

6. The method according to Claim 4, further characterized in that:
the first binary bit coded indicator (FIG. 2A; 24) is a single binary bit.

7. A processor for converting (FIG. 1A) a string of repetitive data comprising a string of binary bits of indefinite length (FIG. 4A) into a compressed impulse format (FIG. 4B) upon which boolean operations can be performed and which is represented by a first value indicating the repetitive data and a second value indicating the number of repetitions, characterized in that the processor comprises:
means for grouping (FIG. 1(A); 14) the successive bits of the string into a corresponding sequence of one or more uncompressed impulses which together constitute substantially the entire bit string (FIG. 4A; 120), each of the one or more uncompressed impulses comprising a run of one or more contiguous bits of the string having the same polarity and an ending bit at one end of the string having a polarity opposite from the said same polarity of the associated impulse (FIG. 4A; 124, 130, 136, 144); and
means for encoding (FIG. 1(A); 14) each of the one or more uncompressed impulses (FIG. 4A; 124, 130, 136, 144) in sequence into a corresponding sequence of compressed impulse formats (FIG. 4B; 142, 150, 154, 168), each having a fixed length (FIG. 2A), one compressed impulse format for each and every uncompressed impulse, the compressed impulse format comprising, for the first value, a first binary bit coded indicator (FIG. 2A; 24) and, for the second value, a second binary bit coded indicator (FIG. 2A; 26), the first indicator (FIG. 2A; 24) indicating the polarity of the one or more same polarity bits of the corresponding uncompressed impulse and the second indicator (FIG. 2A; 26) indicating the quantity of the same polarity bits grouped in the corresponding uncompressed impulse.

8. Apparatus for converting (FIG. 1(A); 14) a string of repetitive data comprising a string of binary bits of indefinite length (FIG. 4A) into a compressed impulse format (FIG. 4B) upon which boolean operations can be performed and which is represented by a first value indicating the repetitive data and a second value indicating the number of repetitions, characterized by:
means for grouping (FIG. 1(A); 14) the successive bits of the string into a corresponding sequence of one or more uncompressed impulses which together constitute substantially the entire bit string (FIG. 4A; 120), each of the one or more uncompressed impulses comprising a run of one or more contiguous bits of the string having the same polarity and an ending bit at one end of the string having a polarity opposite from the said same polarity of the associated impulse (FIG. 4A; 124, 130, 136, 144); and
means for encoding (FIG. 1(A); 14) each of the one or more uncompressed impulses (FIG. 4A; 124, 130, 136, 144) in sequence into a corresponding sequence of compressed impulse formats (FIG. 4B; 142, 150, 154, 168) each having a fixed length (FIG. 2A), one compressed impulse format for each and every uncompressed impulse, the compressed impulse format comprising, for the first value, a first binary bit coded indicator (FIG. 2A; 24) and, for the second value, a second binary bit coded indicator (FIG. 2A; 26), the first indicator (FIG. 2A; 24) indicating the polarity of the one or more same polarity bits of the corresponding uncompressed impulse and the second indicator (FIG. 2A; 26) indicating the quantity of the same polarity bits grouped in the corresponding uncompressed impulse.

## Patentansprüche

1. Verfahren, welches einen Computer zum Umwandeln (Figur 3) einer Kette von sich wiederholenden Daten, die eine Kette binärer Bits unbestimmter Länge (Figur 4A) enthalten, in ein komprimiertes Impulsformat (Figur 4B), mit welchem Boolesche Operationen ausgeführt werden können und welches dargestellt ist durch einen ersten Wert, welcher die sich wiederholenden Daten anzeigt, und einen zweiten Wert, welcher die Anzahl der Wiederholungen anzeigt, verwendet, dadurch gekennzeichnet, daß:
die aufeinanderfolgenden Bits der Kette in eine entsprechende Sequenz eines oder mehrerer nicht komprimierter Impulse gruppiert werden, welche zusammen im wesentlichen die gesamte Bit-Kette (Figur 4A; 120) darstellen, wobei jeder des einen oder der mehreren nicht komprimierten Impulse einen Strang eines oder mehrerer kontinuierlicher Bits der Kette enthält, welcher die gleiche Polarität aufweist und ein End-Bit an einem Ende der Kette aufweist, welches eine gegenüber der gleichen Polarität des assoziierten Impulses (Figur 4A; 124, 130, 136, 144) entgegengesetzte Polarität aufweist; und
jeder der nicht komprimierten Impulse (Figur 4A; 124, 130, 136, 144) in Sequenz in eine entsprechende Sequenz komprimierter Impulsformate (Figur 4B; 142, 150, 154, 168) kodiert wird, wobei jedes eine bestimmte Länge (Figur 2A) und ein komprimiertes Impulsformat für jeden nicht komprimierten Impuls aufweist, wobei das komprimierte Impulsformat als den ersten Wert einen ersten binären Bit-kodierten Indikator (Figur 2A; 24) und als den zweiten Wert einen zweiten binären Bit-kodierten Indikator (Figur 2A; 26) aufweist, wobei der erste Indikator (Figur 2A; 24) die Polarität des einen oder der mehreren Bits gleicher Polarität des entsprechenden nicht komprimierten Impulses zeigt und der zweite Indikator (Figur 2A; 126) die Anzahl der Bits gleicher Polarität anzeigt, die in dem entsprechenden nicht komprimierten Impuls gruppiert sind.

2. Verfahren nach Anspruch 1, weiterhin dadurch gekennzeichnet, daß:
die Anzahl der Bits in den nicht komprimierten Impulsen für eines oder mehrere der Impulse bestimmt wird (Figur 3A; 72); und
die Kodierung des einen oder der mehreren nicht komprimierten Impulse (Figuren 3A - 3B; 83, 89, 90, 92) einschließt, daß Wörter gemeinsamen Formats gebildet werden, die das komprimierte Impulsformat aufweisen und daß in jedem der Wörter gemeinsamen Formats eine Darstellung des ersten Indikators (Figur 2A; 24) und des zweiten Indikators (Figur 2A; 26) für jeden einer variierenden Anzahl des einen oder der mehreren nicht komprimierten Impulse gebildet wird, wobei die variierende Anzahl abhängig von der Anzahl der bestimmten Bits variiert.

3. Verfahren nach nach Anspruch 2, weiterhin dadurch gekennzeichnet, daß:
jedes Wort gemeinsamen Formats zu einem Formatindikator (Figur 2; 22, 28, 38, 52) geformt wird, welcher eine Anzeige der Anzahl des einen oder der mehreren nicht komprimierten Impulse darstellt.

4. Verfahren nach Anspruch 1, in dem die Kodierung des einen oder der mehreren nicht komprimierten Impulse (Figur 4B; 122) weiterhin dadurch gekennzeichnet ist, daß:
jeder des einen oder der mehreren nicht komprimierten Impulse in ein erstes komprimiertes Impulsformat kodiert wird, wenn ein Impuls mit einer Bitlänge von 2 bis 31 Bits (Figur 3; 88, 90) kodiert wird, in ein zweites komprimiertes Impulsformat kodiert wird, wenn ein Impuls mit einer Bitlänge von 32 bis 2³²-1 Bits (Figur 3; 92) kodiert wird, in ein drittes komprimiertes Impulsformat kodiert wird, wenn zwei Impulse kodiert werden, von denen jeder eine Bitlänge von 2 bis 5 Bits (Figur 3; 84, 89, 95, 102) aufweist, oder in ein viertes komprimiertes Impulsformat kodiert wird, wenn drei Impulse kodiert werden, von denen jeder eine Bitlänge von zwei oder drei Bits (Figur 4; 83, 97, 108) aufweist.

5. Verfahren nach Anspruch 1, weiterhin dadurch gekennzeichnet, daß:
der zweite Indikator kodiert wird, um die Anzahl der Bit gleicher Polarität anzuzeigen, die in dem entsprechenden nicht komprimierten Impuls plus dem End-Bit mit einer gegenüber den Bits gleicher Polarität entgegengesetzter Polarität gruppiert sind.

6. Verfahren nach Anspruch 4, weiterhin dadurch gekennzeichnet, daß:
der erste binäre Bit-kodierte Indikator (Figur 2A; 24) ein einzelnes binäres Bit ist.

7. Prozessor zum Umwandeln (Figur 1A) einer Kette von sich wiederholenden Daten, die eine Kette binärer Bits unbestimmter Länge (Figur 4A) enthalten, in ein komprimiertes Impulsformat (Figur 4B), mit welchem Boolesche Operationen ausgeführt werden können und welches dargestellt ist durch einen ersten Wert, welcher die sich wiederholenden Daten anzeigt, und einen zweiten Wert, welcher die Anzahl der Wiederholungen anzeigt, gekennzeichnet durch:
Mittel zum Gruppieren (Figur 1(A); 14) der aufeinanderfolgenden Bits der Kette in einer entsprechende Sequenz eines oder mehrerer nicht komprimierter Impulse, welche zusammen im wesentlichen die gesamte Bit-Kette (Figur 4A; 120) darstellen, wobei jeder des einen oder der mehreren nicht komprimierten Impulse einen Strang eines oder mehrerer kontinuierlicher Bits der Kette enthält, welcher die gleiche Polarität aufweist und ein End-Bit an einem Ende der Kette aufweist, welches eine gegenüber der gleichen Polarität des assoziierten Impulses (Figur 4A; 124, 130, 136, 144) entgegengesetzte Polarität aufweist; und
Mittel zum Kodieren (Figur 1(A); 14) jeder der nicht komprimierten Impulse (Figur 4A; 124, 130, 136, 144) in Sequenz in eine entsprechende Sequenz komprimierter Impulsformate (Figur 4B; 142, 150, 154, 168), wobei jedes eine bestimmte Länge (Figur 2A) und ein komprimiertes Impulsformat für jeden nicht komprimierten Impuls aufweist, wobei das komprimierte Impulsformat als den ersten Wert einen ersten binären Bit-kodierten Indikator (Figur 2A; 24) und als den zweiten Wert einen zweiten binären Bit-kodierten Indikator (Figur 2A; 26) aufweist, wobei der erste Indikator (Figur 2A; 24) die Polarität des einen oder der mehreren Bits gleicher Polarität des entsprechenden nicht komprimierten Impulses zeigt und der zweite Indikator (Figur 2A; 126) die Anzahl der Bits gleicher Polarität anzeigt, die in dem entsprechenden nicht komprimierten Impuls gruppiert sind.

8. Vorrichtung zum Umwandeln (Figur 1A; 14) einer Kette von sich wiederholenden Daten, die eine Kette binärer Bits unbestimmter Länge (Figur 4A) enthalten, in ein komprimiertes Impulsformat (Figur 4B), mit welchem Boolesche Operationen ausgeführt werden können und welches dargestellt ist durch einen ersten Wert, welcher die sich wiederholenden Daten anzeigt, und einen zweiten Wert, welcher die Anzahl der Wiederholungen anzeigt, gekennzeichnet durch:
Mittel zum Gruppieren (Figur 1(A); 14) der aufeinanderfolgenden Bits der Kette in einer entsprechende Sequenz eines oder mehrerer nicht komprimierter Impulse, welche zusammen im wesentlichen die gesamte Bit-Kette (Figur 4A; 120) darstellen, wobei jeder des einen oder der mehreren nicht komprimierten Impulse einen Strang eines oder mehrerer kontinuierlicher Bits der Kette enthält, welcher die gleiche Polarität aufweist und ein End-Bit an einem Ende der Kette aufweist, welches eine gegenüber der gleichen Polarität des assoziierten Impulses (Figur 4A; 124, 130, 136, 144) entgegengesetzte Polarität aufweist; und
Mittel zum Kodieren (Figur 1(A); 14) jeder der nicht komprimierten Impulse (Figur 4A; 124, 130, 136, 144) in Sequenz in eine entsprechende Sequenz komprimierter Impulsformate (Figur 4B; 142, 150, 154, 168), wobei jedes eine bestimmte Länge (Figur 2A) und ein komprimiertes Impulsformat für jeden nicht komprimierten Impuls aufweist, wobei das komprimierte Impulsformat als den ersten Wert einen ersten binären Bit-kodierten Indikator (Figur 2A; 24) und als den zweiten Wert einen zweiten binären Bit-kodierten Indikator (Figur 2A; 26) aufweist, wobei der erste Indikator (Figur 2A; 24) die Polarität des einen oder der mehreren Bits gleicher Polarität des entsprechenden nicht komprimierten Impulses zeigt und der zweite Indikator (Figur 2A; 126) die Anzahl der Bits gleicher Polarität anzeigt, die in dem entsprechenden nicht komprimierten Impuls gruppiert sind.

## Revendications

1. Procédé utilisant un ordinateur, destiné à convertir (Figure 3) une chaîne de données répétitives constituée d'une chaîne de bits binaires de longueur indéfinie (Figure 4A) en un format d'impulsion comprimé (Figure 4B) sur lequel des opérations booléennes peuvent être effectuées et qui est représenté par une première valeur indiquant les données répétitives et une seconde valeur indiquant le nombre de répétitions, caractérisé en ce que:
les bits successifs de la chaîne sont groupés en une séquence correspondante d'une ou plusieurs impulsion(s) non-comprimée(s) qui ensemble constituent sensiblement la totalité de la chaîne de bits (Figure 4A; 120), chacune de ces impulsions non-comprimées comportant une série d'un ou plusieurs bit(s) contigu(s) de la chaîne ayant une polarité identique, et un bit de fin à une extrémité de la chaîne ayant une polarité opposée à ladite polarité identique de l'impulsion associée (Figure 4A; 124, 130, 136, 144); et
chacune des impulsions non-comprimées (Figure 4A; 124, 130, 136, 144) est codée en séquence en une séquence correspondante de formats d'impulsion comprimés (Figure 4B; 142, 150, 154, 168), ayant chacun une longueur fixe (Figure 2A), avec un format d'impulsion comprimé pour chaque impulsion non-comprimée, le format d'impulsion comprimé comportant, pour la première valeur, un premier indicateur codé en binaire (Figure 2A; 24) et, pour la seconde valeur, un second indicateur codé en binaire (Figure 2A; 26), le premier indicateur (Figure 2A; 24) indiquant la polarité du ou des bit(s) de polarité identique de l'impulsion non-comprimée correspondante et le second indicateur (Figure 2A; 26) indiquant la quantité de bits de polarité identique groupés dans l'impulsion non-comprimée correspondante.

2. Procédé selon la revendication 1, caractérisé en outre en ce que:
la quantité de bits dans les impulsions non-comprimées est déterminée (Figure 3A; 72) pour la ou les impulsion(s) ; et
le codage de la ou des impulsion(s) non-comprimées (Figures 3A - 3B; 83, 89, 90, 92) comprend la formation de mots de format commun ayant le format d'impulsion comprimé, et la formation, dans chacun des mots de format commun, d'une représentation du premier indicateur (Figure 2A; 24) et du second indicateur (Figure 2A; 26) pour chacune d'un nombre variable d'impulsions non-comprimées, où un tel nombre variable varie en fonction de la quantité de bits déterminée.

3. Procédé selon la revendication 2, caractérisé en outre en ce que:
chaque mot de format commun est formé en un indicateur de format (Figure 2; 22, 28, 38, 52) qui indique le nombre des impulsions non-comprimées.

4. Procédé selon la revendication 1, dans lequel le codage de la ou des impulsion(s) non-comprimée(s) (Figure 4B; 122) est en outre caractérisé en ce que:
chacune des impulsions non-comprimées est codée en un premier format d'impulsion comprimé lors du codage d'une impulsion dont la longueur est comprise entre 2 et 31 bits (Figure 3; 88, 90), en un deuxième format d'impulsion comprimé lors du codage d'une impulsion dont la longueur est comprise entre 32 et 2³² - bits (Figure 3; 92), en un troisième format d'impulsion comprimé lors du codage de deux impulsions dont la longueur de chacune est comprise entre 2 et 5 bits (Figure 3; 84, 89, 95, 102) ou en un quatrième format d'impulsion comprimé lors du codage de trois impulsions dont la longueur de chacune est égale à 2 ou 3 bits (Figure 4; 83, 97, 108).

5. Procédé selon la revendication 1, caractérisé en outre en ce que:
le second indicateur est codé de façon à indiquer la quantité de bits de parité identique groupés dans l'impulsion non-comprimée correspondante, ainsi que le bit de fin dont la polarité est opposée à celle desdits bits de parité identique.

6. Procédé selon la revendication 4, caractérisé en outre en ce que:
le premier indicateur codé en binaire (Figure 2A; 24) comporte un bit binaire unique.

7. Processeur destiné à convertir (Figure 1A) une chaîne de données répétitives constituée d'une chaîne de bits binaires de longueur indéfinie (Figure 4A) en un format d'impulsion comprimé (Figure 4B) sur lequel des opérations booléennes peuvent être effectuées et qui est représenté par une première valeur indiquant les données répétitives et une seconde valeur indiquant le nombre de répétitions, caractérisé en ce que le processeur comprend:
un moyen destiné à grouper (Figure 1A; 14) les bits successifs de la chaîne en une séquence correspondante d'une ou plusieurs impulsion(s) non-comprimée(s) qui ensemble constituent sensiblement la totalité de la chaîne de bits (Figure 4A; 120), chacune de ces impulsions non-comprimées comportant une série d'un ou plusieurs bit(s) contigu(s) de la chaîne ayant une polarité identique, et un bit de fin à une extrémité de la chaîne ayant une polarité opposée à ladite polarité identique de l'impulsion associée (Figure 4A; 124, 130, 136, 144); et
un moyen destiné à coder (Figure 1A; 14) chacune des impulsions non-comprimées (Figure 4A; 124, 130, 136, 144) en séquence en une séquence correspondante de formats d'impulsion comprimés (Figure 4B; 142, 150, 154, 168), ayant chacun une longueur fixe (Figure 2A), avec un format d'impulsion comprimé pour chaque impulsion non-comprimée, le format d'impulsion comprimé comportant, pour la première valeur, un premier indicateur codé en binaire (Figure 2A; 24) et, pour la seconde valeur, un second indicateur codé en binaire (Figure 2A; 26), le premier indicateur (Figure 2A; 24) indiquant la polarité du ou des bit(s) de polarité identique de l'impulsion non-comprimée correspondante et le second indicateur (Figure 2A; 26) indiquant la quantité de bits de polarité identique groupés dans l'impulsion non-comprimée correspondante.

8. Appareil destiné à convertir (Figure 1A; 14) une chaîne de données répétitives constituée d'une chaîne de bits binaires de longueur indéfinie (Figure 4A) en un format d'impulsion comprimé (Figure 4B) sur lequel des opérations booléennes peuvent être effectuées et qui est représenté par une première valeur indiquant les données répétitives et une seconde valeur indiquant le nombre de répétitions, caractérisé par:
un moyen destiné à grouper (Figure 1A; 14) les bits successifs de la chaîne en une séquence correspondante d'une ou plusieurs impulsion(s) non-comprimée(s) qui ensemble constituent sensiblement la totalité de la chaîne de bits (Figure 4A; 120), chacune de ces impulsions non-comprimées comportant une série d'un ou plusieurs bit(s) contigu(s) de la chaîne ayant une polarité identique, et un bit de fin à une extrémité de la chaîne ayant une polarité opposée à ladite polarité identique de l'impulsion associée (Figure 4A; 124, 130, 136, 144); et
un moyen destiné à coder (Figure 1A; 14) chacune des impulsions non-comprimées (Figure 4A; 124, 130, 136, 144) en séquence en une séquence correspondante de formats d'impulsion comprimés (Figure 4B; 142, 150, 154, 168), ayant chacun une longueur fixe (Figure 2A), avec un format d'impulsion comprimé pour chaque impulsion non-comprimée, le format d'impulsion comprimé comportant, pour la première valeur, un premier indicateur codé en binaire (Figure 2A; 24) et, pour la seconde valeur, un second indicateur codé en binaire (Figure 2A; 26), le premier indicateur (Figure 2A; 24) indiquant la polarité du ou des bit(s) de polarité identique de l'impulsion non-comprimée correspondante et le second indicateur (Figure 2A; 26) indiquant la quantité de bits de polarité identique groupés dans l'impulsion non-comprimée correspondante.
